(19) Europäisches Patentamt
European Patent Office
Office européen des brevets

(11) **EP 2 284 908 B1**

(12) **EUROPEAN PATENT SPECIFICATION**

(45) Date of publication and mention of the grant of the patent:
**05.12.2018 Bulletin 2018/49**

(21) Application number: **09734549.0**

(22) Date of filing: **21.04.2009**

(51) Int Cl.:
*H02S 40/34* [(2014.01)]   *H02S 40/36* [(2014.01)]
*H01L 31/02* [(2006.01)]

(86) International application number:
**PCT/JP2009/057923**

(87) International publication number:
**WO 2009/131120 (29.10.2009 Gazette 2009/44)**

(54) **POWER LINES FOR SOLAR POWER GENERATION SYSTEM AND METHOD FOR INSPECTING MALFUNCTION OF THE SOLAR POWER GENERATION SYSTEM**

STROMLEITUNGEN FÜR EIN SOLARSTROMERZEUGUNGSSYSTEM UND VERFAHREN ZUR UNTERSUCHUNG EINER FEHLFUNKTION DES SOLARSTROMERZEUGUNGSSYSTEMS

LIGNE ELECTRIQUE POUR SYSTEME DE GENERATION D'ENERGIE SOLAIRE ET PROCEDE D'INSPECTION DES ANOMALIES DU SYSTEME DE GENERATION D'ENERGIE SOLAIRE

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **23.04.2008 JP 2008113141**

(43) Date of publication of application:
**16.02.2011 Bulletin 2011/07**

(73) Proprietor: **Sharp Kabushiki Kaisha**
**Osaka-shi, Osaka 545-8522 (JP)**

(72) Inventors:
- **SHIMIZU, Akira**
  **Osaka-shi, Osaka 545-8522 (JP)**
- **HASEGAWA, Masatomo**
  **Osaka-shi, Osaka 545-8522 (JP)**
- **MAEDA, Kengo**
  **Osaka-shi, Osaka 545-8522 (JP)**
- **ODAGAKI, Keiji**
  **Osaka-shi, Osaka 545-8522 (JP)**
- **MITSUOKA, Hirofumi**
  **Osaka-shi, Osaka 545-8522 (JP)**

(74) Representative: **Müller Hoffmann & Partner**
**Patentanwälte mbB**
**St.-Martin-Strasse 58**
**81541 München (DE)**

(56) References cited:
EP-A1- 1 705 718          WO-A1-2007/086472
DE-A1-102004 036 697      JP-A- 2000 277 787
JP-A- 2002 185 029        JP-A- 2003 031 834
JP-A- 2005 044 824        US-B1- 6 515 215

## Description

### TECHNICAL FIELD

The present invention relates to power lines for solar power generation system for connecting a plurality of thin-film solar cell modules to junction boxes, current collection boxes, inverters or the like, and solar power generation system using using them. In particular, it relates to power lines for solar power generation system to which a protection unit such as a blocking diode, a fuse or a shut-off circuit is connected to protect output reduction of the solar power generation system. Further, it relates to a method for inspecting malfunction of the solar power generation system.

### BACKGROUND ART

For example, Patent Document 1 discloses that a plurality of solar cell modules are connected in series (which are referred to as "solar cell strings", hereinafter) and the solar cell strings are connected in parallel to structure solar cell arrays for a solar power generation system. Patent Document 1 also discloses that direct currents from the solar cell arrays are collected to a junction box and connected to the inverter, and supplied to a load. The junction box includes a circuit for connecting the respective solar cell strings in parallel, a surge absorber, a blocking element, a shut-off switch of the respective strings and a shut-off switch of the direct current side.

EP 1 705 718 A1 discloses an array having two branches connected electrically in parallel by opposite ends of positive and negative polarities, respectively. Each branch has photoelectric cells. One end has a blocking module to block an electrical current coming from a nearest branch. Another end has a blocking module to limit the propagation of a flash over, towards the nearest branch, induced by an electric arc at a level of the cell of related branch, to a value less than or equal to a rated current value of the related branch ranging between 0 and 0.5 A.

US 6 515 215 B1 discloses a photovoltaic module comprising a photovoltaics and a signal generation means for generating a signal by application of a voltage, wherein the photovoltaics and the signal generating means are connected in parallel and the voltage is a voltage output by the photovoltaics which is connected in parallel with at least the signal generating means, thereby enabling detection of and detect a failed photovoltaic module, regardless of the structure of a photovoltaic module array or the failure mode of the photovoltaic module.

DE 10 2004 036697 A1 discloses that a cooling plate consisting of high-heat conduction material is arranged contacting a bypass diode on a base plate made of aluminum or copper. The heat generated during diode operation is transmitted towards direction of solar cell panel through base plate.

### PRIOR ART DOCUMENTS

[Patent Document 1] Japanese Unexamined Patent Publication No. HEI 10(1998)-326902

### DISCLOSURE OF THE INVENTION

### PROBLEMS TO BE SOLVED BY THE INVENTION

In Patent Document 1, the blocking element is provided within the junction box. In such a case, however, the respective solar cell strings constituting the solar cell arrays must be constructed such that the output lines thereof are extended to the respective junction boxes, whereby the cost of wiring the lines and the troubles for the wiring works are increased. Especially, when the number of providing the solar cell strings in parallel is great or it is far between the solar cell strings and the junction boxes, these problems become outstanding.

In view of these problems, an object of the present invention is to reduce cost of wiring the lines and simplify wiring works by reducing extension cables from solar cell strings to a junction box under the construction that a blocking diode is provided which is connected in a branch line of a power line to construct parallel connection of solar cell strings at a close portion to solar cell modules.

Another object of the present invention is to provide a solar power generation system using such power lines for the solar power generation system.

A further object of the present invention is to provide a method for inspecting malfunction of such a solar power generation system.

### MEANS FOR SOLVING THE PROBLEMS

The above objects are achieved by the claimed matter according to the independent claims.

In order to solve the above-described problems, a power line system for a solar power generation system of the present invention comprises trunk lines for extracting power, a plurality of branch lines interconnected in parallel which are connected across the trunk lines, and solar cell modules connected to the branch lines, wherein a protection unit is provided which is connected to one of the branch lines.

Using such power lines, a plurality of solar cell modules can be connected in parallel through the protection units connected to the branch lines so that the power generation outputs from the solar cells are collected to the trunk lines and together transferred to junction boxes to enable the reduction in cost of wiring the lines and the simplification of wiring works.

According to one embodiment of the power lines for the solar power generation system of the present invention, it is constructed that the protection units are a blocking diode, and the power lines for the solar power generation system of the present invention are constructed so that one terminal of the blocking diode is connected to the trunk lines and the other terminal thereof is connected to the solar cell strings through the branch lines.

Further, according to the present invention, it is constructed that a branch connection unit is provided at a connection portion between the trunk lines and the brunch lines and a heat sink is stored within the branch connection unit, the terminal of the blocking diode being connected to the heat sink which is connected to either the trunk lines or the brunch lines, so as to dissipate the heat of the blocking diode through the heat sink.

Moreover, according to the present invention, the branch connection unit for connecting the trunk lines and the branch lines includes a built-in heat sink for dissipating the heat of the blocking diode within the inside thereof, the trunk lines being connected to the built-in heat sink. The heat sink is adapted to serve as a terminal plate to connect one of connection terminals of the diode to the trunk lines. The blocking diode is adapted to be thermally combined with the heat sink. The blocking diode is stored within a container into which a potting agent is filled. According to this construction, the heat of the blocking diode can be effectively dissipated.

According to one embodiment of the power lines for the solar power generation system of the present invention, the trunk lines are thicker at the junction box end and are thinner at the distal end at the branch connection unit between the trunk lines and the branch lines.

A solar power generation system of the present invention is constructed using the above-mentioned power lines for the solar power generation system. Thus, the solar power generation system of the present invention is provided which enables the reduction in cost of wiring the lines and the simplification of the wiring works.

In one embodiment, the solar power generation system of the present invention is constructed so that trunk lines comprise low-voltage side wiring and high-voltage side wiring, and the blocking diode is connected to the branch lines coupled to the low-voltage side wiring.

Further, the solar power generation system of the present invention is constructed so that the low-voltage side wiring and the high-voltage side wiring are collectively integrated, and the branch lines connected to the low-voltage side wiring and the high-voltage side are positioned across both sides of the trunk lines, respectively, so that the solar cell modules are connected to the branch lines.

Moreover, it is featured that the low-voltage side wiring and the high-voltage side wiring are constructed to be collectively integrated, and the branch lines connected to the low-voltage side wiring are positioned at one side of the trunk lines, while the branch lines connected to the high-voltage side wiring are positioned at the other side of the trunk lines, so that the solar cell modules are each connected to the branch lines, and connection lines for connecting the solar cell modules are provided.

In another aspect of the present invention, the present invention is featured to be a method for inspecting malfunction of a solar power generation system, comprising providing a blocking diode with the branch lines connected to a low-voltage side wiring or high-voltage side wiring and applying a voltage from the trunk lines including the branch lines to which the blocking diode is unconnected, wherein earth resistances of solar cell modules are inspected or heat generation of solar cell modules is observed.

Thereby, the malfunction of the solar power generation system can be inspected by the simple observation.

## EFFECTS OF THE INVENTION

According to the power lines for the solar power generation system of the present invention, the solar power generation system is provided which enables the reduction in cost of wiring lines and the simplification of wiring works.

According to the present invention, it is possible to detect malfunction or earth fault failure of a blocking diode in a system using the blocking diode, so that the solar power generation system with high reliability and easy maintenance can be provided.

## BRIEF DESCRIPTION OF THE DRAWINGS

FIG. 1 is a block diagram of Embodiment 1 using power lines for a solar power generation system of the present invention.

FIG. 2 is an explanatory diagram showing a construction of the power lines for a solar power generation system of the present invention.

FIG. 3 is a perspective view, a plan view, a sectional view, a circuit diagram and a specific construction of a branch connection unit employed for the power lines for the solar power generation system of the present invention.

FIG. 4 is another block diagram of Embodiment 1 using the power lines for the solar power generation system of the present invention.

FIG. 5 is an explanatory diagram showing a connection construction of a solar power generation system of the present invention.

FIG. 6 is an explanatory diagram showing a first example of the solar power generation system of the present invention.

FIG. 7 is a more detailed explanatory diagram showing the first example of the solar power generation system of the present invention.

FIG. 8 is an explanatory diagram showing a second example of the solar power generation system of the present invention.

FIG. 9 is a more detailed explanatory diagram showing the second example of the solar power generation system of the present invention.

FIG. 10 is a varied explanatory diagram showing the second example of the solar power generation system of the present invention.

FIG. 11 is a plan view and a sectional view of a first thin-film solar cell module employed for the solar power generation system of the present invention.

FIG. 12 is a circuit diagram of the first thin-film solar cell module employed for the solar power generation system of the present invention.

FIG. 13 is a diagram showing the relationship between short-circuit resistances Rsh and Prsh, when the short-circuit resistance Rsh varies, of a thin-film solar cell module employed for the solar power generation system of the present invention.

FIG. 14 is a diagram illustrating distribution of the short-circuit resistance Rsh of a thin-film solar cell module employed for the solar power generation system of the present invention.

FIG. 15 is a plan view and a sectional view of a second thin-film solar cell module employed for the solar power generation system of the present invention.

FIG. 16 is a circuit diagram of the second thin-film solar cell module employed for the solar power generation system of the present invention.

FIG. 17 is a plan view and a sectional view of a third thin-film solar cell module employed for the solar power generation system of the present invention.

FIG. 18 is a circuit diagram of the third thin-film solar cell module employed for the solar power generation system of the present invention.

FIG. 19 is a plan view and a sectional view of a fourth thin-film solar cell module employed for the solar power generation system of the present invention.

FIG. 20 is a block diagram of Embodiment 2 using the power lines for the solar power generation system of the present invention.

FIG. 21 is a block diagram of Embodiment 3 using the power lines for the solar power generation system of the present invention.

FIG. 22 is an explanatory diagram of detecting short-circuit fault in the solar power generation system of the present invention.

FIG. 23 is an explanatory diagram of detecting open-circuit fault in the solar power generation system of the present invention.

**BEST MODE FOR CARRYING OUT THE INVENTION**

(Embodiment 1)

<Block diagram of Embodiment 1>

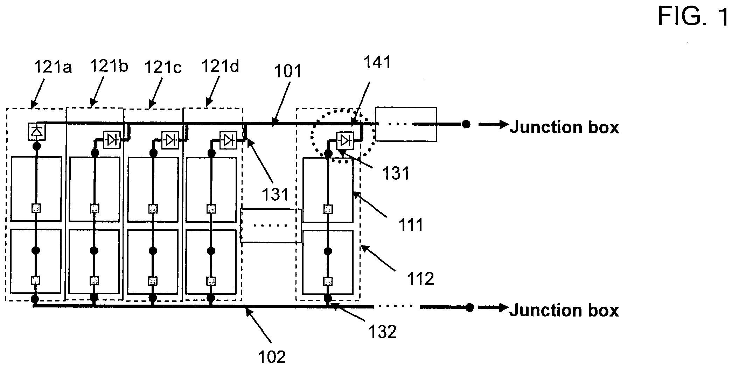

FIG. 1 is a block diagram of Embodiment 1 of the present invention. As shown in FIG. 1, two solar cell modules 111 and 112 are interconnected in series to construct a solar cell string 121. A plurality of solar cell strings 121 are interconnected in parallel across trunk lines 101 and 102 to be connected to e.g., a junction box (not shown). The junction box is further connected to e.g., a DC/AC converter (not shown) as a power conversion device to supply power to a load. Otherwise, it may be connected to a commercial power line to form grid connection.

The present invention is featured by comprising the trunk lines 101 and 102 for collecting the power of the solar cell strings 121, branch lines 131 and 132 for connecting the solar cell strings 121 to the trunk lines 101 and 102 and a blocking diode 141 connected to the branch line 131 or 132.

Though FIG.1 shows a solar power generation system comprising a plurality of solar cell strings each including two solar cell modules interconnected in series, the number of the solar cell modules and the solar cell strings is not limited and it is possible to provide a desired number of the solar cell modules and the solar cell strings required for small scale power generating systems to large scale power generating systems.

The solar cell modules 111 and 112 will be described in detail from <first thin-film solar cell module> to <fourth thin-film solar cell module>.

<Construction of power lines for solar power generation system>

A plurality of solar cell strings 121 are interconnected in parallel in which as increasing the interconnection number of the solar cell strings 121, a current next to the junction box becomes great. For this reason, copper wires for the trunk lines 101 and 102 are used which are different in diameter having a sectional area of 6.0 mm$^2$ to 2.0 mm$^2$ in turn next to the junction box, according to the number of the solar cell strings 121 interconnected.

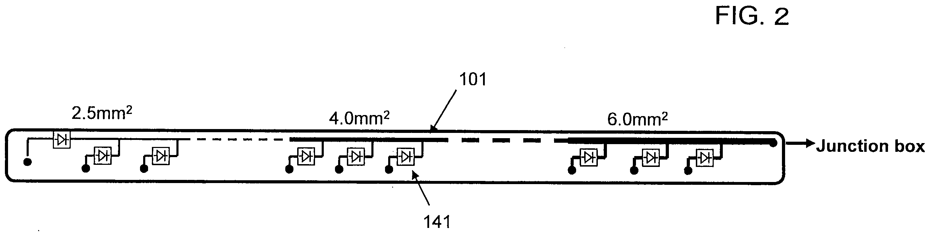

FIG. 2 shows this situation in which as increasing the interconnection number of the solar cell strings 121, the trunk lines 101 and 102 are used which have a sectional area of 5.5 mm$^2$ to 6.0 mm$^2$ at the junction box side starting from the point that the current is 30 A or more, the lines 101 and 102 are used which have a sectional area of 3.5 mm$^2$ to 4.0 mm$^2$ at the junction box side starting from the point that the current is 20 A or more, and they are used which have a sectional area of 2.0 mm$^2$ to 2.5 mm$^2$ at the junction box side starting from the point that the current is 10 A or more. Thus, the trunk lines 101 and 102 may be different in thickness. These current values and the thickness of these wires are only exemplified and the above values are not strictly limited to, because it is necessary to allow a little safety margin.

<Branch connection unit>

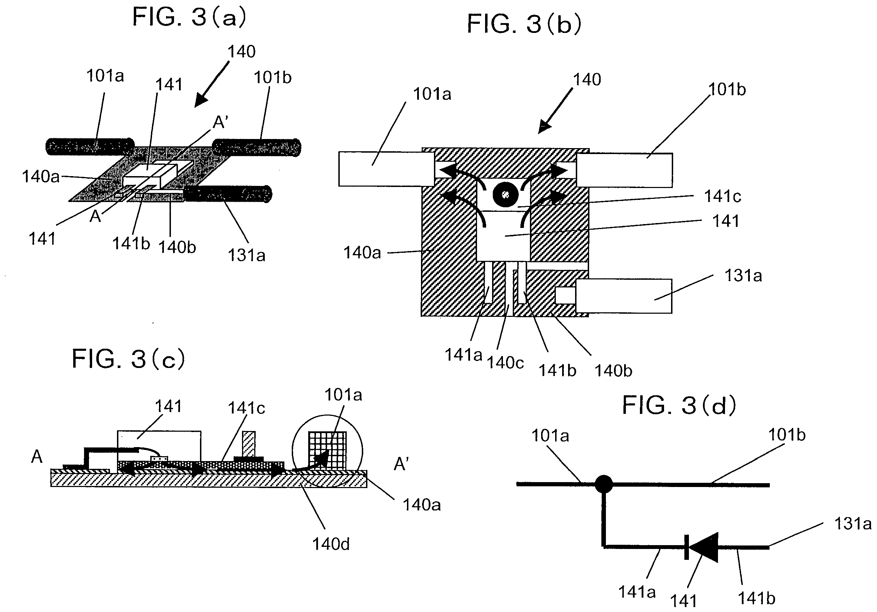

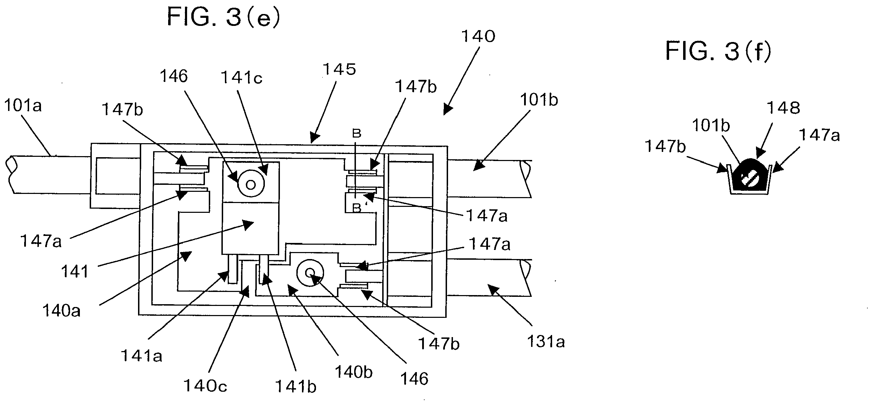

FIG. 3 shows a branch connection unit 140 for connecting the trunk lines 101 and the branch line 131. FIG. 3 (a) is a schematic diagram of the branch connection unit 140, FIG. 3 (b) is a plan view of the branch connection unit 140, FIG. 3 (c) is a sectional view of the branch connection unit 140, taken on line A-A' of FIG. 3(a), FIG. 3 (d) is a circuit diagram of the branch connection unit 140, and FIG. 3 (e) is a specific construction of the branch connection unit 140.

As shown in FIG. 3(a), the branch connection unit 140 comprises a large heat sink 140a coupled to one terminal 141a of a blocking diode 141. One end of the large heat sink 140a is coupled to a trunk line 101a at a side next to the junction box, while the other end thereof is coupled to a trunk line 101b at a distal side. The other terminal 141b of the blocking diode 141 is coupled to a small heat sink 140b, further coupled to a branch line 131a, and further coupled to the solar cell string. The large heat sink 140a and the small heat sink 140b are positioned having a satisfactory space 140c (1.5 mm in this embodiment) complied with a withstand voltage required by the solar power generation system, so as to prevent short circuit of them.

FIG. 3 (b) is a plan view of the branch connection unit 140, in which the large heat sink 140a is positioned between the trunk lines 101a and 101b, and one end of the large heat sink 140a is coupled to the trunk line 101a at the side next to the junction box. The other end of the large heat sink 140a is coupled to the trunk line 101b at the distal side. As an electric circuit, the trunk lines 101a and 101b may be coupled to any portions of the large heat sink 140a. However, from the point of view of dissipating heat, it is preferably that the trunk lines 101a and 101b be positioned next to the heat generation portion of the blocking diode 141 so that the heat generated from the blocking diode 141 is dissipated to the trunk lines 101a and 101b. That is, whereas during the power generation operation, a current flows through the blocking diode 141 and the trunk lines 101a and 101b to generate heat, the heat temperature generated from the blocking diode 141 is higher so that the heat from the blocking diode 141 conducts through the trunk lines 101a and 101b via the large heat sink 140a as shown by arrows in FIG. 3 (b). The trunk lines 101a and 101b are very long and are made of thick wires enough to flow the generated current, thereby providing a high heat dissipation effect.

Though the blocking diode 141 is positioned within the branch connection unit 140 between the trunk line 101 and the branch line 131 in FIG. 3, the blocking diode 141 may be inserted within the branch line 131 so that the blocking diode 141 is coupled in the middle of the branch line 131. Even if the blocking diode 141 is coupled in the middle of the branch line 131, the blocking diode 141 may be adapted to be thermally combined with the large heat sink 140a.

The large heat sink 140a may be adapted to serve as a terminal plate to connect one of connection terminals 141a and 141b of the blocking diode 141 to the trunk line 101.

Further, the large heat sink 140a may be adapted to be integrated with the package of the blocking diode 141, and the large heat sink 140a may be adapted to be thermally combined with the trunk line 101.

As shown in FIG. 3 (c) illustrating a sectional view of the branch connection unit 140, taken on line A-A' of FIG.

3(a), the large heat sink 140a and the small heat sink 140b are positioned on a base 140d of the container of the branch connection unit 140, while the blocking diode 141 is installed on the large heat sink 140a. A built-in heat sink 141c is provided with the blocking diode 141 so that the built-in heat sink 141c of the blocking diode 141 is pressed so as to contact with the large heat sink 140a in a surface contact and be thermally combined therewith. Preferably, an adhesive resin with good thermal conductivity is interposed between the built-in heat sink 141c and the large heat sink 140a. For example, an epoxy resin, silicone grease or thermal conductive silicone resin with thermal conductivity may be suitable.

One terminal 141a of the blocking diode 141 is coupled to the trunk lines 101a and 101b through the large heat sink 140a. The other terminal 141b of the blocking diode 141 is coupled to the branch line 131a through the small heat sink 140b.

As shown by the arrows in FIG. 3 (c), the heat generated from the blocking diode 141 is dissipated by the built-in heat sink 141c and the large heat sink 140a and drifted to the trunk lines 101a and 101b to be further dissipated by them. Since, according to the construction of the present invention, the heat is dissipated by the trunk lines 101a and 101b, the area of the built-in heat sink 141c and the large heat sink 140a can be minimized. Although the large heat sink 140a is used in FIG. 3, when the built-in heat sink 141c is provided with the blocking diode 141, it is possible that the heat from the built-in heat sink 141c is drifted to the trunk lines 101a and 101b for dissipating the heat by thermally combining the trunk lines 101a and 101b with the built-in heat sink 141c.

As shown in FIG. 3(d), the electric circuit of the blocking diode 141 is such that one terminal 141a of the blocking diode 141 is coupled to the trunk lines 101a and 101b and the other terminal 141b thereof is coupled to the branch line 131a.

FIG. 3(e) shows a specific construction of the branch connection unit 140, in which the branch connection unit 140 is stored in a box 145 made of PPS (Polyphenylene Sulfide) with high resistance to heat and a lid (not shown) made of PPE (Polyphenylene ether) with high flexibility, namely, a product of PPO (Poliophenylene oxide) ®. These resin materials are only examples, and any other resin can be used. Further, it may be possible that the box and the lid are made of the same resin. In such a case, when PPS is used, it is preferable to be highly resistant to atmosphere change.

When a box 145 made of PPS is used, the large heat sink 140a and the small heat sink 140b are positioned on the base of the box 145 made of PPS, so that the blocking diode 141 is positioned on the large heat sink 140a. The large heat sink 140a and the small heat sink 140b are formed with the same shape as the base of the box 145 and positioned having the space 140c. The blocking diode 141 and the large heat sink 140a are simultaneously fixed to the base of the box 145 with a fixing tool 146 such as a rivet. The small heat sink 140b is fixed to the base of the box 145 with a fixing tool 146 such as a rivet.

Hence, one terminal 141a of the blocking diode 141 is in contact with the large heat sink 140a, and the other terminal 141b is in contact with the small heat sink 140b, while the trunk lines 101a and 101b are in contact with the large heat sink 140a, and the branch line 131 is in contact with the small heat sink 140b, so that solder pastes are affixed on the respective contact portions and they pass through a reflow furnace to solder the contact portions. When passing through the reflow furnace, preferably, the contact portions only are heated without heating the trunk lines 101a and 101b and the branch line 131a. Other than using the reflow furnace for soldering, a manual soldering operation may be used. As described next, electrical connection may be used by filling a resin to push the respective contact portions.

FIG. 3 (f) is a sectional view taken on line B-B' of FIG. 3(e), in which two upright pieces 147a and 147b are formed at the solder portions between the large heat sink 140a and the trunk line 101b, by cutting parts of the large heat sink 140a and uprighting them almost perpendicularly. A terminal of the trunk line 101b is inserted between the two upright pieces 147a and 147b to make a solder 148. Similarly, two upright pieces are formed at the solder portions between both the large heat sink 140a and each of the trunk line 101 and the branch line 131a, by cutting parts of the large heat sink 140a and the small heat sink 140b and uprighting them almost perpendicularly. Terminals of the trunk line and the branch line are inserted between the two upright pieces to make a solder 148.

The shapes and the upright angles of the two upright pieces 147a and 147b from the large heat sink 140a and the small heat sink 140b are only one example and desired shapes and angles may be used.

Though the two upright pieces 147a and 147b from the large heat sink 140a and the small heat sink 140b are made by cutting and uprighting parts of the large heat sink 140a and the small heat sink 140b, any other soldering portions can be provided.

Thus, by providing a solder receiving portion, the solder can be prevented from being flown to another portion to assure the soldering. Since the upright pieces make sides for the solder portion, the contact area of the solder portion can be enlarged so that the heat of the large heat sink 140a and the small heat sink 140b can be drifted to the trunk lines, effectively.

After the respective contact portions are thus soldered, a curing resin is potted within the box 145. As the curing resin, silicone and epoxy resin are used, but any other resin such as an addition type, a heat type, a UV curing type and a condensation type can be used. However, the two-part addition type of resin is most preferable since it can be cured regardless of the moisture. When the condensation type of resin is used, a two-part condensation type of resin is preferable since it is hardly dependent upon the moisture. Since an one-part condensation type of resin absorbs the moisture from the atmosphere, the control of a curing speed is difficult because the silicone may be chapped depending upon the curing conditions to cause insulation fault. Since, especially, the power lines for the solar power generation system of the present invention are used outside the house in which it is assumed that water may pool around the power lines or the power lines may be soaked within a pool, the one-part condensation type of resin may cause insulation fault. The heat type of resin must be further heated after the resin has been filled. The box made of PPS and the lid made of PPO should have heat resistance as well as the blocking diode BD. In addition, the solder portions should not fall off. The UV curing type of resin requires radiation of ultra violet rays.

As a resin for potting inside the box of the blocking diode according to the present invention, the specific examples listed below are suitable. As the one-part condensation type of resin, KE-4890 (product name), KE-4896 (product name) each of Sin-Etsu Chemical Co., Ltd., TSE-399 (product name), TSE-392 (product name) each of Momentive Performance Materials Worldwide Inc. and SE-9185 (product name), SE-9188 (product name) each of Dow Corning Toray Co., Ltd. are listed. As the two-part condensation type of resin, KE-200 (product name) of Sin-Etsu Chemical Co., Ltd. is listed. As the addition type of resin, KE1204 (product name) of Sin-Etsu Chemical Co., Ltd. and EE1840, Sylgard184 (product name) each of Dow Corning Toray Co., Ltd. are listed.

As mentioned above, by filling the potting resin, the thermal conductivity of the potting resin is larger than the atmosphere to become possible to expect the heat dissipation effect.

The blocking diode 141 is stored within a container formed by the box 145 made of PPS and the lid made of PPO, while the trunk lines 101a and 101b are introduced into the inside of the container through a hole created in the box made of PPO. When the trunk line 101a or 101b is introduced through the hole, the trunk line 101a or 101b is pushed into the hole, and the surfaces of the hole and the trunk line 101a or 101b are coated and adhered with an adhesive. Further, since according to the present invention, the potting agent is potted into the container, after the trunk line 101a or 101b is soldered and coupled to the large heat sink 140a, the trunk line 101a or 101b is fixed by the potting agent. By thus potting the agent, the trunk line 101a or 101b is pushed into and fixed in the hole by the adhesive between the hole and the trunk line 101a or 101b and further fixed by the potting agent.

<Another block diagram of Embodiment 1>

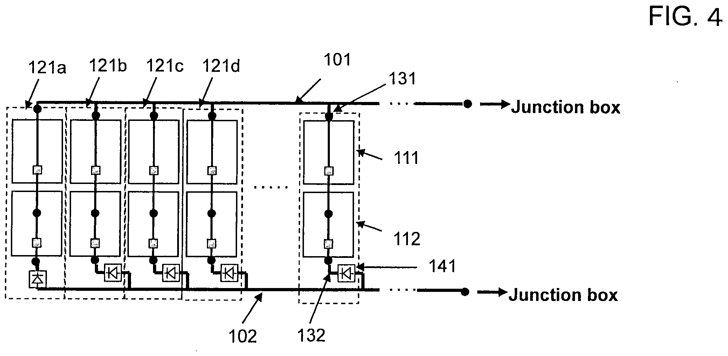

In FIG. 1, the blocking diode 141 is positioned at the side of the trunk line 101. The trunk line 101 is high-voltage side wiring of the solar cell string 100. On the contrary, as shown in FIG. 4, the blocking diode 141 may be positioned at the side of the trunk line 102. The trunk line 102 is low-voltage side wiring of a solar cell string 121. Here, the high-voltage side wiring means plus-electrode side wiring of the solar cell string 121. Further, the low-voltage side wiring means minus-electrode side wiring of the solar cell string 121. In the case where the blocking diode 141 is thus positioned at the low-voltage side wiring of the trunk line 102, an earth fault examination of the solar cell string 121 can be easily made. That is, when a plurality of solar cell strings 121 are interconnected across the trunk lines 101 and 102 and one of the strings causes earth fault, an electric current is supplied from the junction box so that the electric current flows through the solar cell string 121 causing the earth fault, because the blocking diode 141 is not connected between the junction box and the solar cell string 121 causing the earth fault. Detecting this electric current enables the solar cell string 121 causing the earth fault to be detected.

When such a cable is used for wiring, it is an important problem to detect malfunction of the built-in blocking diode. According to the present invention, it is suggested to make a confirmation on this respect by applying a voltage from the side of the trunk lines to examine this fault.

For a specific procedure, while the solar cells do not generate power at night, a voltage is applied to the trunk lines for examination. The direction of the voltage to be applied is such that the high-voltage side wiring is set plus and the low-voltage side wiring is set minus. Since this voltage direction is reverse to the direction of the blocking diode, the normal conditions of all the blocking diodes prevent any electric current from flowing. If at least one of the blocking diodes is at fault in a short-circuit mode, an electric current can flow so that a solar cell string connected to the diode at fault generates heat. It is observed by a thermograph so that it is easily possible to identify a solar cell string at fault even when a great number of solar cell modules are provided in a large-scale power generation system.

If one of the blocking diodes is at fault in an open-circuit mode, it is impossible to identify the solar cell string connected to the blocking diodes at fault by the above method. In such a case, however, the output from the solar cell string connected to the blocking diodes at fault cannot be taken out. Therefore, it is possible to detect it by examining operation currents and generated power in comparing them between a plurality of arrays while the solar cells generate power in the daytime.

<Connection construction of solar power generation system>

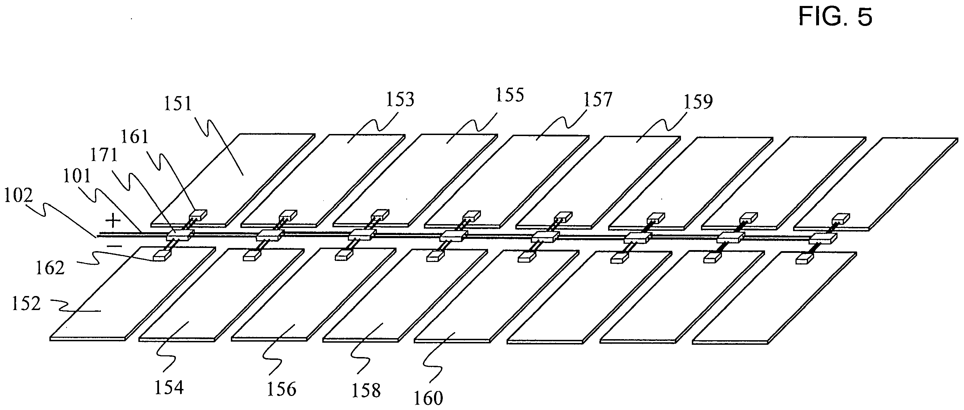

The solar power generation system as shown in FIG.1 or 4 represents the construction that the plurality of the solar cell strings 121 are interconnected in parallel across the trunk lines 101 and 102. On the contrary, according to the embodiments as shown in FIGs. 5 to 10, the two trunk lines 101 and 102 are positioned to be collectively integrated.

The integration of the two trunk lines 101 and 102 may be formed as a two-line wire having a pair of wires, or the two trunk lines 101 and 102 may be closely positioned.

Further, in the case where the container is provided for storing the blocking diode in the branch connection unit as shown in FIG. 3, the respective container portions corresponding to the two trunk lines 101 and 102 may be unified, or the container portions may be individual.

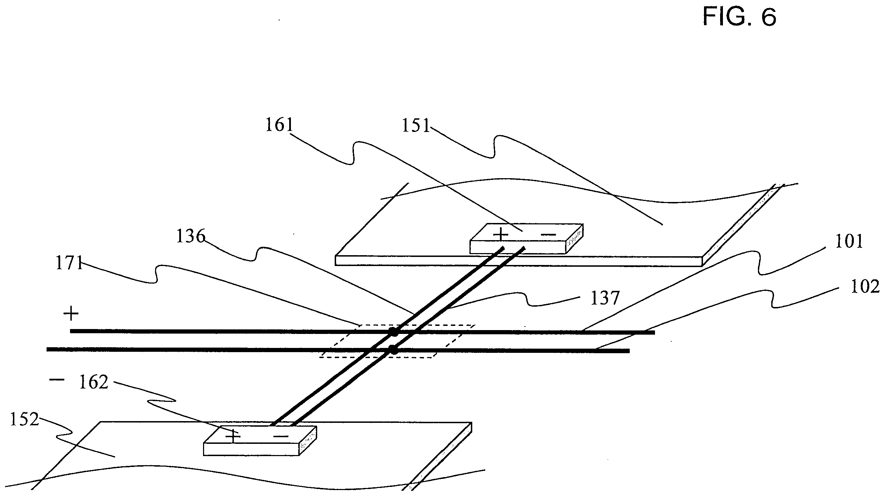

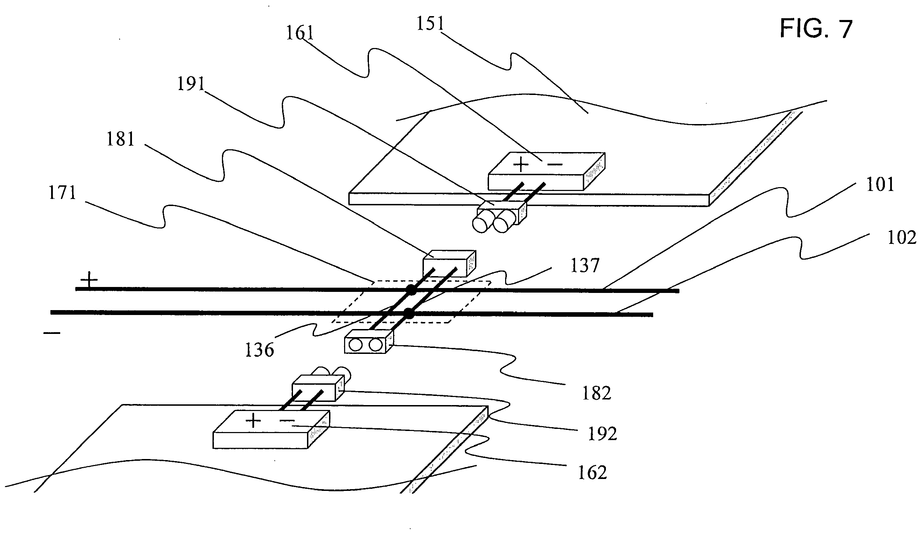

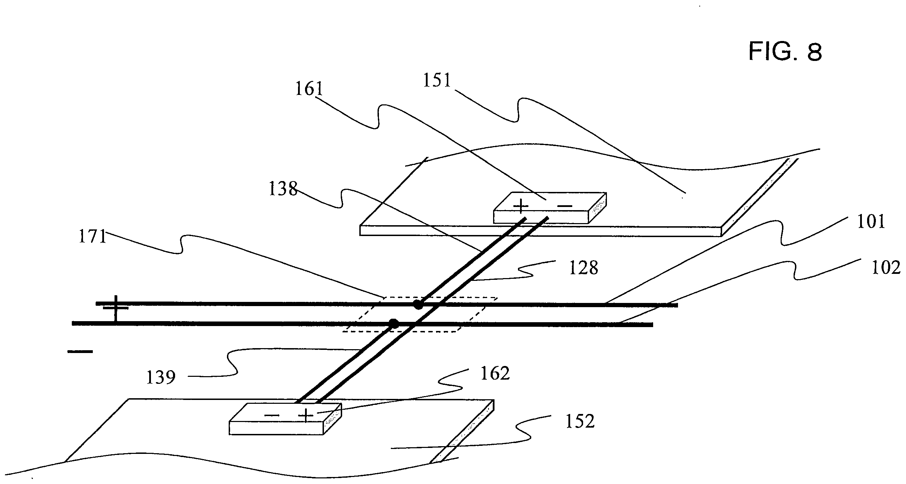

FIG. 5 shows an explanatory diagram illustrating two examples as described below. FIGs. 6 and 7 show a first example and FIGs. 8 to 10 show a second example. According to these examples, a solar cell panel is formed by finalizing a solar cell string having two solar cell modules connected in series with a stainless steel frame, a surface protective glass and a rear surface reinforcement plate. The two trunk lines 101 and 102 are positioned between the thus formed solar cell panels 151 and 152, and those panels 153 and 154...... Each terminal box 171 of the solar cell panels is positioned at the position close to the trunk lines 101 and 102, so that the length of a wire for connecting the plurality of the solar cell panels to the trunk lines 101 and 102 can be minimized. Further, in the case where this embodiment is applied to a solar power generation system in which solar cell strings having small current and high voltage are connected in series, the wires of the trunk lines 101 and 102 can be used to be thinner. In addition, since the two-line connectors can be easily adopted, the connection portions can be minimized for providing the parallel connection, as compared to the case where the wires are extended to a connection box per each solar cell string.

As shown in FIG.5, according to the first and second examples, the high-voltage side wiring 101 and the low-voltage side wiring 102 are collectively integrated and positioned. The terminal unit 171 is positioned between the two solar cell panels 151 and 152. The solar cell panels 151, 152, .... are positioned at both sides of the trunk lines 101 and 102. Branch lines 131 and 132 are provided for connecting the respective terminal boxes 161, 162, ... of the solar cell panels 151, 152, ... so that the solar cell panels 151, 152, ... are connected in parallel.

For one example of arranging the solar power generation system, a line of solar cell panels are aligned along the trunk lines 101 and 102 so that the terminal boxes of the solar cell panels are positioned at the side close to the trunk lines, whereby, preferably, the wiring from the terminal boxes of the solar cell panels to the trunk lines is less than half of the shorter side of the solar cell panels. In this manner, the branch lines are shortened for providing the effects to reduce voltage drop due to resistance components of the power lines, improve workability in positioning the solar cell panels, and save wiring materials or the like.

For another example of arranging the solar power generation system, each line of solar cell panels are aligned at both sides of the trunk lines so that the terminal boxes of both ends of the solar cell panels are positioned as confronting to each other at the side close to the trunk lines, whereby the wiring from the terminal boxes of the solar cell panels to the trunk lines may be less than half of the shorter side of the solar cell panels. In this manner, the branch lines are shortened for providing the effects to reduce voltage drop due to resistance components of the power lines, improve workability in positioning the solar cell panels, and save wiring materials or the like.

<First example>

FIG. 6 shows a more detailed explanatory diagram showing a first example in which the trunk lines 101 and 102, the connection unit 171 and the terminal boxes 161 and 162 of the solar cell panels 151 and 152 are connected. As shown in FIG. 6, the connection unit 171 is formed in the trunk lines 101 and 102, and the terminal boxes 161 and 162 of the solar cell panels 151 and 152 are connected to the connection unit 171.

FIG. 7 shows the connection unit 171 and the terminal boxes 161 and 162 in detail. As shown in FIG. 7, a branch line 136 is coupled 1 to a first trunk side connector 181 and a second trunk side connector 182 from the high-voltage side trunk line 101 of the connection unit 17. Further, a branch line 137 is coupled to the first trunk side connector 181 and the second trunk side connector 182 from the low-voltage side trunk line 102 of the connection unit 171. The first trunk side connector 181 and the second trunk side connector 182 are positioned at both sides of the trunk lines 101 and 102 across them as shown in FIG. 7. A module side connector 191 detachable to the first trunk side connector 181 is positioned as opposed to the first trunk side connector 181. Similarly, a module side connector 192 detachable to the second trunk side connector 182 is positioned as opposed to the second trunk side connector 182.

The module side connector 191 is connected to the terminal box 161 of the solar cell panel 151. The module side connector 192 is connected to the terminal box 162 of the solar cell panel 152. The terminal boxes 161 and 162 each include the blocking diode 141, as described as the branch connection unit 140 in FIG. 3.

<Second example>

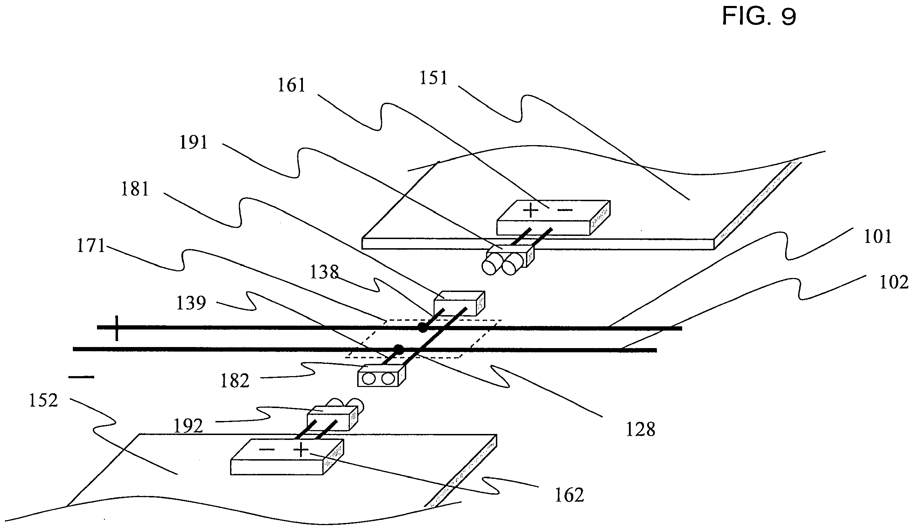

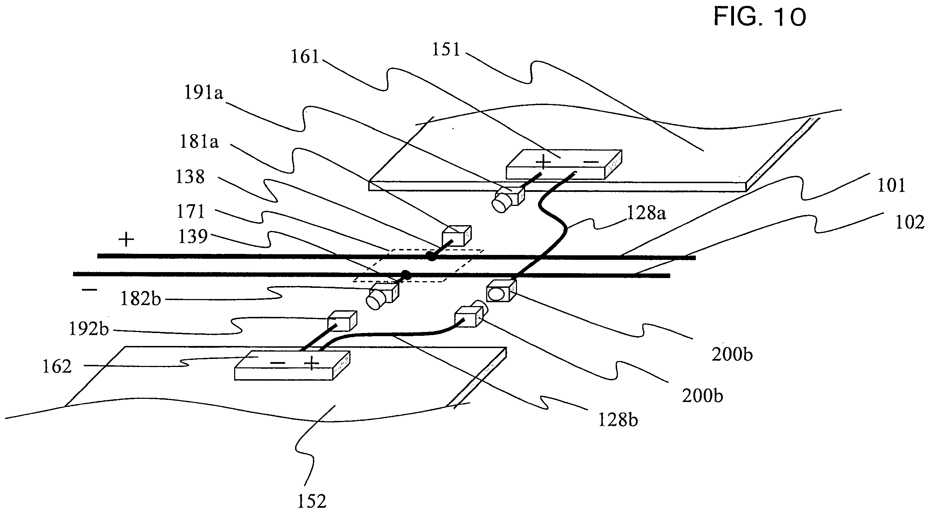

FIGs. 8 to 10 show an explanatory diagram of a second example. FIG. 9 shows a more detailed explanatory diagram of the second example, and FIG. 10 shows a varied explanatory diagram of the second example. FIG. 8 shows an explanatory diagram common to the second example.

As shown in FIG. 8, in the second example, two solar cell panels 151 and 152 respectively positioned at both sides of the trunk lines 101 and 102 are connected in series. Namely, a branch line 138 coupled to the high-voltage side trunk line 101 from the connection unit 171 of the trunk lines 101 and 102 is connected to a plus electrode of the terminal box 161 of the solar cell panel 151. A branch line 139 coupled to the low-voltage side trunk line 102 is connected to a minus electrode of the terminal box 162 of the solar cell panel 152. Further, a branch line 128 is provided for connecting a minus electrode of the terminal box 161 of the solar cell panel 151 and a plus electrode of the terminal box 162 of the solar cell panel 152.

FIG. 9 is a more detailed explanatory diagram showing the connection unit 171 and the terminal boxes 161 and 162. As shown in FIG. 9, the branch line 138 is coupled to the first trunk side connector 181 from the high-voltage side trunk line 101 of the connection unit 171. Similarly, the branch line 139 is coupled to the second trunk side connector 182 from the low-voltage side trunk line 102 of the connection unit 171. The branch line 128 couples the first trunk side connector 181 and the second trunk side connector 182. The module side connector 191 detachable to the first trunk side connector 181 is positioned as opposed to the first trunk side connector 181. Similarly, the module side connector 192 detachable to the second trunk side connector 182 is positioned as opposed to the second trunk side connector 182. The module side connector 191 is connected to the terminal box 161 of the solar cell panel 151. The module side connector 192 is connected to the terminal box 162 of the solar cell panel 152. The terminal boxes 161 and 162 each include the blocking diode 141, as described as the branch connection unit 140 in FIG. 3. Therefore, the module side connector 191 is inserted into the first trunk side connector 181 and the module side connector 192 is inserted into the second trunk side connector 182 so that the two solar cell panels 151 and 152 are connected in series and coupled across the high-voltage side trunk line 101 and the low-voltage side trunk line 102.

FIG. 10 is a varied diagram of FIG. 9 in which the branch line 128 for connecting the solar cell panels 151 and 152 is featured to be divided into branch lines 128a and 128b the tips of which are connected to connectors 200a and 200b, respectively. The first connector 181 in FIG. 9 is a first connector 181a having a single line (FIG. 10) connected to a branch line 138, and the second connector 182 in FIG. 9 is a second connector 181b having a single line (FIG. 10) connected to a branch line 139, so that the connectors 181a and 182b of FIG. 10 can be minimized than the connectors 181 and 182 of FIG. 9. Thus, the branch line 128 for connecting the solar cell panels 151 and 152 in series are divided into the branch lines 128a and 128b so that the branch lines 128a and 128b can be connected around the outsides of the solar cell panels 151 and 152 for the wiring of the branch lines to become free.

According to the wiring as described in the examples of the present invention, the wiring from the terminal boxes to the trunk lines can be shortened. In particular, in the case where the modules are directly coupled to each other without using these trunk cables in order to couple the modules to each other, it is necessary for each module to be connected by a cable having at least a length more than a half of the shorter side of the module so as to couple the modules to each other, so that the cable extending from the module has at least a total length more than a half of the shorter side of the module. On the contrary, the wiring as described above according to the present invention, the wiring from the modules to the trunk lines can be shortened such that the total length is much shorter than a half length of the modules, even summing the total of the plus and minus branch lines and the module output lines. When the trunk lines are extended between two lines of the module, the total length of the wiring can be shortened even considering the wiring length of the trunk lines.

Next, the solar cell strings for outputting the high power will be described.

An output voltage Vdc of each solar cell string is set to be approximately $\sqrt{2}$ times to several 10 times the AC output voltage (effective value) of the DC/AC converter DA. Therefore, the output voltage Vdc of the solar cell strings is 140 V to 1000 V, when the AC output voltage is 100 V. According to the present invention, direct input to the DC/AC converter is possible. Furthermore, since any number of solar cell strings can be connected in parallel, the present invention can be applied to small scale power generating systems to large scale power generating systems. Moreover, it is ideal that all the output voltages of the solar cell modules are equal, and in that case, it is possible to take out the maximum power; however, in the present invention, the solar cell modules are connected in parallel, and therefore it is possible to take out power effectively even if all the solar cell modules do not output an equal output voltage.

The above-described solar cell modules comprise a thin-film solar cell string comprising a plurality of thin-film solar cell elements interconnected in series, each of the thin-film solar cell elements including a surface electrode, a photoelectric conversion layer, and a back surface electrode laminated in this order. The photovoltaic power system requiring a high voltage as much as several hundreds V and the photovoltaic power system for residence use or the like that links with commercial power can be achieved by using a thin-film solar cell module that is configured as follows.

<First thin-film solar cell module>

- Example of 53 stages × 12 parallels × 2 blocks in series -

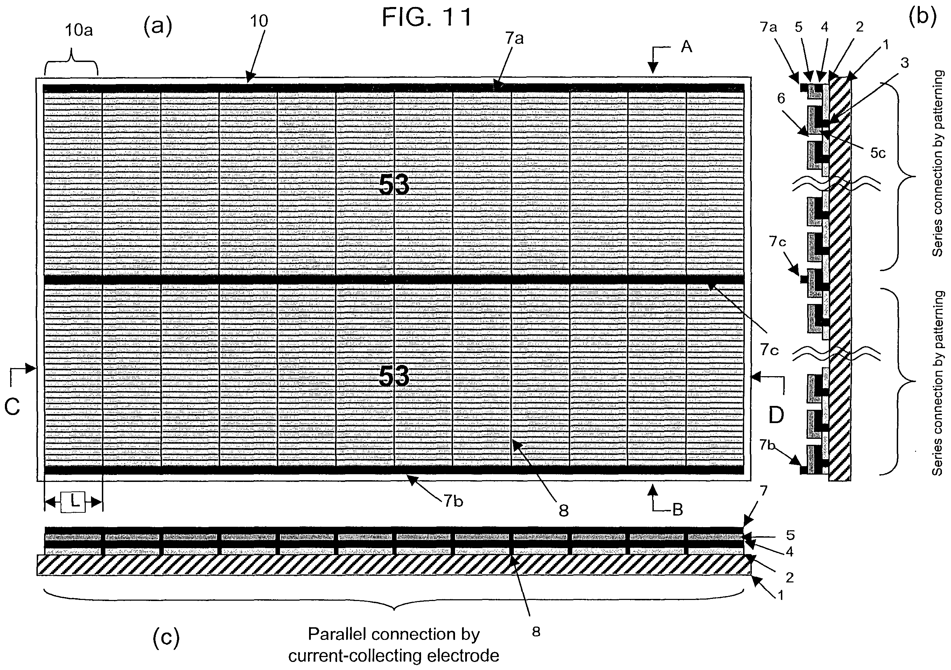

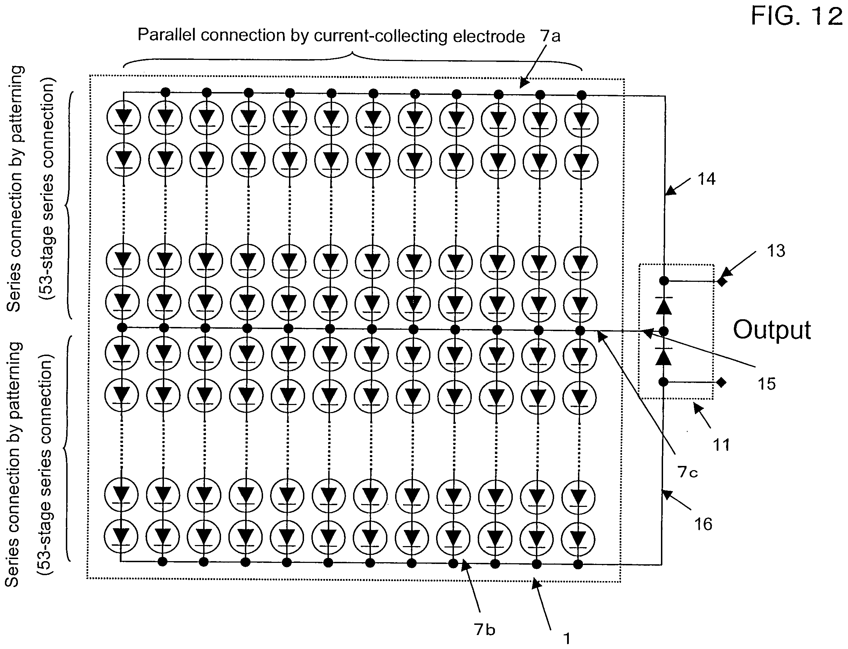

FIG. 11 illustrates an integrated thin-film solar cell module associated with the first thin-film solar cell module, and FIG. 11 (a) is a plan view, FIG. 11 (b) is a cross-sectional view taken along lines A-B of FIG. 11 (a), and FIG. 11 (c) is a cross-sectional view taken along lines C-D of FIG. 11 (a). FIG. 12 illustrates a circuit diagram.

In the first thin-film solar cell module, a supporting substrate 1 is, for example, a translucent glass substrate or a resin substrate such as a polyimide. On the substrate (surface), a first electrode (for example, a transparent conductive film of $SnO_2$ (tin oxide)) is formed by a thermal CVD method or the like. As long as the first electrode is a transparent electrode, it may be, for example, ITO which is a mixture of $SnO_2$ and $In_2O_3$. Thereafter, the transparent conductive film is appropriately removed by patterning to form dividing scribe lines 3. Formation of the dividing scribe lines 3 forms the first electrode 2 that is divided into several pieces. The dividing scribe lines 3 are formed by cutting the first electrode by a groove-like shape (scribe line shape) by means of a laser scribing beam, for example.

Next, on the first electrode 2, a photoelectric conversion layer 4 is formed by forming a film of semiconductor layers (for example, amorphous silicon or microcrystalline silicon) of, for example, p-type, i-type, and n-type in sequence by a CVD method. At the same time, the dividing scribe lines 3 are also filled with the photoelectric conversion layer. The photoelectric conversion layer 4 may be of a p-n junction or a p-i-n junction. In addition, the photoelectric conversion layer 4 may be laminated into one, two, three, or more stages, and sensitivity of each solar cell element may be made to sequentially shift to a longer wavelength as it is distant from the substrate side. When the photoelectric conversion layer is laminated into a plurality of layers as described above, the layers may include a layer such as a contact layer and an intermediate reflection layer therebetween.

When the photoelectric conversion layer 4 is laminated into a plurality of layers, all the semiconductor layers may be an amorphous semiconductor or a microcrystalline semiconductor, or may be any combination of an amorphous semiconductor and a microcrystalline semiconductor. That is, the structure may be a laminate in which the first photoelectric conversion layer is of an amorphous semiconductor and the second and third photoelectric conversion layers are of a microcrystalline semiconductor; a laminate in which the first and second photoelectric conversion layers are of an amorphous semiconductor and the third photoelectric conversion layer is of a microcrystalline semiconductor; or a laminate in which the first photoelectric conversion layer is of a microcrystalline semiconductor and the second and third photoelectric conversion layers are of an amorphous semiconductor.

In addition, while the above-described photoelectric conversion layer 4 is of a p-n junction or a p-i-n junction, it may be of an n-p junction or an n-i-p junction. Furthermore, the p-type semiconductor layer and the i-type semiconductor layer may or may not have a buffer layer of an i-type amorphous material therebetween. Usually, in the p-type semiconductor layer, a p-type impurity atom such as boron and aluminum is doped, and in the n-type semiconductor layer, an n-type impurity atom such as phosphorus is doped. The i-type semiconductor layer may be completely undoped or may be of a weak p-type or a weak n-type including a small amount of impurity.

The photoelectric conversion layer 4 is not limited to silicon, and may be formed of a silicon semiconductor such as silicon carbide containing carbon or silicon germanium containing germanium, or a compound semiconductor of a compound such as Cu(InGa)Se2, CdTe, and $CuInSe_2$.

Here, each photoelectric conversion layer 4 of the thin-film solar cell module as shown in FIG.11 is of a p-i-n junction, constituting a three-junction type thin-film solar cell of a laminate of three cells of amorphous silicon/amorphous silicon/microcrystalline silicon.

Then, connection grooves are formed on the photoelectric conversion layer 4 by laser scribing or the like, and a second electrode (ZnO/Ag electrode or the like) is formed thereon by sputtering or the like. As a result, the connection grooves are filled with the second electrode material, and contact lines 5c are formed. As a result, the second electrode 5 divided on the photoelectric conversion layer 4 and the adjacent first electrode 2 on the photoelectric conversion layer 4 will be connected via the contact lines 5c, and a plurality of thin-film solar cell elements will be connected in series. Furthermore, cell dividing grooves 6 are formed in parallel with the contact lines 5c by laser scribing or the like to divide the thin-film solar cell elements to a plurality of pieces. Thereby, in an example of FIG. 11, each individual solar cell element (cell) is divided to be in an equal size, and a thin-film solar cell string 10 (hereinafter, may be referred to as cell string) is formed, having a plurality of solar cell elements connected in series in the vertical direction of FIG. 11.

The thin-film solar cell module of the present invention comprises a thin-film solar cell string comprising thin-film solar cell elements interconnected in series, each of the thin-film solar cell elements including a surface electrode, a photoelectric conversion layer, and a back surface electrode laminated in this order, the thin-film solar cell module being configured so that the number of stages n of the series connection of the thin-film solar cell elements in the thin-film solar cell string satisfies the following formula (1):

$$n < Rshm \, / \, 2.5 \, / \, Vpm \times Ipm + 1 \quad (1),$$

wherein Rshm is the most frequent short-circuit resistance value of the thin-film solar cell elements;
Vpm is an optimum operation voltage of the thin-film solar cell elements; and

Ipm is an optimum operation current of the thin-film solar cell elements.

When in operation, a solar cell array having the thin-film solar cell module of the above-described configuration built therein is in a state where the output of the thin-film solar cell string is short-circuited by a bypass diode, when the thin-film solar cell string comprising n stages of solar cell elements integrated is in a hotspot state due to one stage of thin-film solar cell elements of those being in shade. An equivalent circuit in the module in this case is in a state where (n-1) stages of thin-film solar cell elements in light have one stage of thin-film solar cell elements not in light connected thereto as a load. Therefore, most power generated in the region being in light in the thin-film solar cell string will be consumed in the thin-film solar cell elements in shade, without being taken out of the thin-film solar cell string. Then, when the reverse breakdown voltage is sufficiently high in the normal region of the thin-film solar cell elements in shade, the current that flows to the thin-film solar cell elements goes to a region within the surface short-circuited by dust, flaws, and protrusions, and a region of low resistance around the laser scribing and the like.

Measures of how easy the current flows include the short-circuit resistance to be worked out from current-voltage characteristics when a backward voltage of approximately 0 to several V is applied to the thin-film solar cell elements. When the short-circuit resistance is Rsh [Ω], the power is most concentrated on the short-circuit part when the short-circuit resistance Rsh is equal to an optimum load Rshpm with respect to the (n-1) stages of cells in light. Therefore, the module needs to be designed so that the short-circuit resistance Rsh is prevented from being close to the value.

For example, an optimum load Rshpm is reached as in the following formula (2), which is the worst, where an optimum operation voltage is Vpm [V] and an optimum operation current is Ipm [A] with respect to one stage of thin-film solar cell elements, and one stage of thin-film solar cell elements are in shade, as described above.

$$\mathrm{Rshpm} = \mathrm{Vpm} \ / \ \mathrm{Ipm} \times (\mathrm{n}\text{-}1) \quad (2)$$

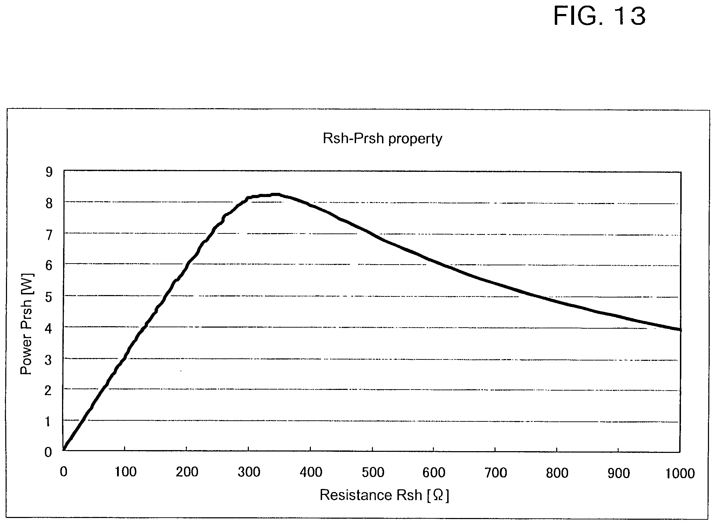

An actual short-circuit resistance Rsh is caused by various causes such as a region within the surface short-circuited by dust, flaws and protrusions, and a region of low resistance around the laser scribing. Rsh varies due to various reasons in a production step, distributed within a certain range. FIG. 13 illustrates the relationship between the short-circuit resistance Rsh and power Prsh consumed there according to I-V properties of a representative silicon thin-film solar cell. When the above-described short-circuit resistance Rsh is approximately 2.5 times the optimum load Rshpm, deviating from the optimum load Rshpm, the power Prsh decreases to half or less.

That is, in FIG. 13, the power is approximately 8 W when the optimum load Rshpm is approximately 330 Ω, and the power is approximately 4 W when the short-circuit resistance Rsh is 130 Ω. Therefore, it is possible to considerably reduce occurrence of peel-off due to a hotspot, if production can be carried out with the short-circuit resistance Rsh deviated from the optimum load Rshpm by 2.5 times or more. No matter how much the short-circuit load Rsh deviates from the optimum load Rshpm, it is acceptable as long as the deviation is by 2.5 times or more, because the deviation needs only to be by 2.5 times or more.

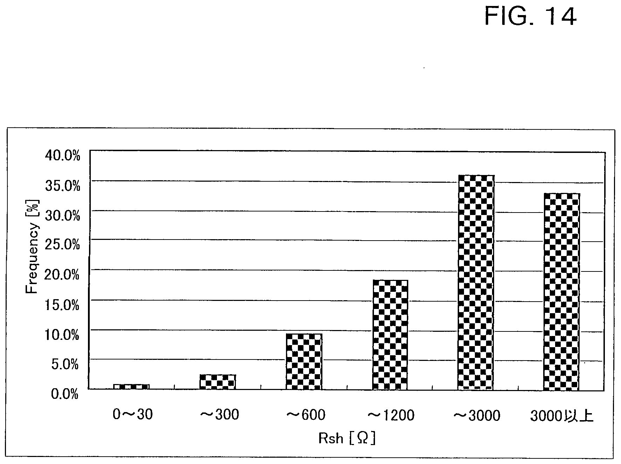

In addition, FIG. 14 illustrates distribution of the short-circuit resistance Rsh of a module actually produced. Factors that impair (= lower) the short-circuit resistance Rsh of the thin-film solar cell elements may include various events such as insufficient division at the dividing scribe lines; short circuit due to dust, protrusions, and pin holes within the surface; increase of reverse leakage current due to variation of production conditions; and lowered resistance of a doped layer. As a main factor around the peak of the distribution of short-circuit resistance Rsh (around 3000 Ω), however, leakage current at the dividing scribe lines mainly causes the lowering of the short-circuit resistance Rsh. In a range of the distribution of the short-circuit resistance Rsh lower than the vicinity of the peak, leakage current within the surface mainly causes the lowering of the short-circuit resistance Rsh.

When the factor of the leakage current is a short circuit within the surface, and a hotspot phenomenon occurs, the short-circuit region within the surface is peeled off or burnt off to cause high resistance. Therefore, F.F. of the cell is improved, offsetting lowering of Isc due to the peel-off. As a result, it is unlikely that the properties deteriorate significantly. However, when the factor of the leakage current is leakage current at the dividing scribe lines, and a hotspot phenomenon occurs, peel-off is generated from the dividing scribe lines. Then, solar cell elements in a normal region are involved to promote the peel-off or affect contact lines nearby. Therefore, in the case of leakage current at the dividing scribe lines, the properties and reliability of the thin-film solar cell module deteriorate significantly compared to the case of leakage current due to the short circuit within the surface.

It is therefore desirable that the above-mentioned optimum load Rshpm comes outside a range where the main factor is leakage current at the dividing scribe lines and stays within a range where the main factor is leakage current within the surface. Specifically, when the most frequent short-circuit resistance value Rsh is Rshm, the optimum load Rshpm needs to be within a range of sufficiently low level with respect to Rshm. Since the short-circuit resistance Prsh for the most frequent value Rshm is approximately half of the short-circuit resistance Prsh for the optimum load Rshpm when the most frequent value Rshm is 2.5 times the optimum load Rshpm, parameters need to be selected so that the following formula (3) is satisfied:

$$\mathrm{Rshm} > 2.5 \times \mathrm{Rshpm} = 2.5 \times \mathrm{Vpm} \div \mathrm{Ipm} \times (n\text{-}1) \qquad (3)$$

Once type, structure, and production conditions of the solar cell elements constituting the thin-film solar cell module are determined, Vpm, Ipm, and Rshm are almost determined, and then the following formula (1) is obtained by modifying the formula (3). Thereby, the maximum number of integration stages that can keep hotspot resistance is determined.

$$n < \mathrm{Rshm} \div 2.5 \div \mathrm{Vpm} \times \mathrm{Ipm} + 1 \qquad (1)$$

Practically, Rshm > approximately 2000 Ω and Vpm / Ipm = approximately 5 to 10 Ω in reasonable solar cell elements, because too low short-circuit resistance Rsh affects solar cell element properties, though it depends on the form of the solar cell elements. Here, n < 80 to 160. In the case of solar cell elements for which the optimum operation voltage Vpm = approximately 1.0 V, any thin-film solar cell modules having an optimum operation voltage of approximately 80 to 160 V will naturally fall within the range.

The problem becomes significant only when the optimum operation voltage of the module is more than approximately 160 V. As a countermeasure for this case, we have found that the problem can be prevented if the number of integration stages is determined so as to meet the formula (1).

In addition, when the maximum number of integration stages is limited in this way and it is desired to obtain a voltage output higher than a voltage output that can be achieved with the number of integration stages as the thin-film solar cell module, the inside of the thin-film solar cell module is divided to a plurality of blocks so that the number of integration stages in each block falls within the range of the formula (1). Furthermore, if each block is provided with a bypass diode attached thereto in parallel and connected mutually in series, a thin-film solar cell module of high voltage output can be achieved, while ensuring its hotspot resistance. This is because the bypass diode, being attached in parallel, works at the time of the occurrence of hotspot to almost short-circuit the output of the block, thereby preventing influence of the other blocks.

Furthermore, cell string dividing grooves 8 running in the vertical direction of FIG. 11(a) are formed in the cell string 10 produced in that way to divide the cell string 10 to a plurality of pieces in the transverse direction of FIG. 11, thereby forming unit cell strings 10a. Here, the division to the unit cell strings is performed to hold power generation per unit cell string 10a to a certain value or lower for improvement of the hotspot resistance. The smaller output Pa of the unit cell strings 10a is, the better, in terms of prevention of damages to the cells due to a hotspot phenomenon. The upper limit of the output Pa of the unit cell strings is obtained by a cell hotspot resistance test to be described later, which is 12 W. The output Pa of the unit cell strings can be calculated according to the following formula (4):

$$\mathrm{Pa} = (\mathrm{P} \ / \ \mathrm{S}) \times \mathrm{Sa} \qquad (4),$$

wherein

P is the output of the thin-film solar cell module;
S is the area of the effective power generation region of the thin-film solar cell module; and
Sa is the area of the unit cell strings 10a.

In order to lower output Ps of the unit cell strings 10a when output P of the thin-film solar cell module is constant, the number of unit cell strings 10a included in the thin-film solar cell module needs to be increased, that is, the number of string dividing grooves 8 needs to be increased. The more the number of parallel division stages is, the more advantageous, when considering only the upper limit of the output Ps of the unit cell strings 10a. However, when the number of parallel division stages is increased, power density applied to the contact lines (P - Ps) / Sc increases, and the contact lines 5c become likely to be damaged for the following reasons (1) to (3). Here, P is the output of the thin-film solar cell module, Ps is the output possible from the cell string in shade, and Sc is the area of the contact lines 5c.

(1) Increase of power applied from the other unit cell strings

When one unit cell string 10a is in shade, power generated in all the other cell strings is applied to the unit cell string 10a in shade. The value of the power applied to the unit cell string 10a in shade is (P - Ps). When the number of parallel divisions is increased to reduce the output Pa of the unit cell string 10a, the power to be applied to the unit cell string 10a in shade increases, because the smaller the value of the output Pa of the unit cell string 10a is, the larger the value of the (P - Ps) is.

(2) Decrease of contact line area

When the number of parallel divisions is increased, a length L of the contact lines 5c illustrated in FIG. 11(b) is shortened, and, as a result, an area Sc of the contact lines 5c is made smaller. As a result, the value of resistance of the contact lines 5c increases.

(3) Increase of applied power density in connection grooves

As described above, the value of the (P - Ps) increases, and the area Sc of the contact P lines is made smaller, when the number of parallel divisions is increased. Therefore, the power density (P - Ps) / Sc applied to the contact lines 5c increases, and the contact lines 5c become likely to be damaged.

In order to prevent damage of the contact lines 5c, it is necessary to hold the power density (P - Ps) / Sc applied to the contact lines 5c to the upper limit thereof or lower. The upper limit of the power density (P - Ps) / Sc applied to the contact lines 5c can be determined according to the reverse overcurrent resistance test to be described later, which was 10.7 ($kW/cm^2$). The power density (P - Ps) / Sc applied to the contact lines is not limited in particular as long as it is 10.7 ($kW/cm^2$) or less.

Here, a cell hotspot resistance test will be described.

At first, the first thin-film solar cell modules are produced and a reverse voltage of 5 V to 8 V is applied thereto, and the modules are measured for I-V and the current obtained when the reverse current is varied from 0.019 $mA/cm^2$ to 6.44 $mA/cm^2$ (referred to as RB current). Out of the measured samples, samples having different reverse currents are divided in parallel so that the output of the string to be evaluated is 5 to 50 W. Then, a hotspot resistance test is performed on a thin-film solar cell element (one cell). The hotspot resistance test was in accordance with ICE 61646, 1st EDITION. Here, however, the acceptance line was made severer by 10% in terms of an aim to make the appearance better. As for the peeled area, the area of a region where a film is peeled off was measured by photographing the sample surface from the substrate side of the thin-film solar cell module. Results of the measurement on the samples having different cell string outputs or RB currents have revealed that cases of moderate RB currents (0.31 to 2.06 $mA/cm^2$) are prone to peel-off of a film. It has been also revealed that the peeled area can be held to 5% or less regardless of the magnitude of the RB current, when the output of the cell string is 12 W or less. Thus, the output Ps of the unit cell string was set to 12 W or less.

Next, the reverse overcurrent resistance test will be described.

At first, the first thin-film solar cell modules were produced, and the reverse overcurrent resistance test was performed by applying an overcurrent in a direction opposite to the direction of the power generation current and examining damage of the contact lines. According to the provisions of IEC 61730, the current to be applied here should be 1.35 times the anti-overcurrent specification value, and was set to 5.5 A at 70 V here.

When the above-specified voltage and current are applied to the thin-film solar cell module, the current is divided to be applied to the cell strings connected in parallel. However, the current is not divided equally, because the value of resistance varies from cell string to cell string. In the worst case, all the 5.5A at 70 V may be applied to one cell string. It is necessary to perform the test to see whether or not the cell string is damaged even in the worst case. Therefore, samples were produced with the width of the contact lines changed to 20 $\mu$m and 40 $\mu$m and the length of the contact lines changed to 8.2 mm to 37.5 cm to judge damage of the contact lines by visual inspection. As a result, it has been revealed that the area of the contact lines should be 20 $\mu$m × 18 cm or 40 $\mu$m × 9 cm = 0.036 $cm^2$ or more. The power applied to the cell strings is 385 W, which leads to 385 W ÷ 0.036 $cm^2$ = 10.7 ($kW/cm^2$).

After the string dividing grooves 8 are formed as described above, the cell string 10 is divided into two, upper and lower, regions by using a metal electrode 7. Specifically, a current-collecting electrode 7a is attached to the upper end in FIG. 11 and a current-collecting electrode 7b is attached to the lower end in FIG. 11, and the unit cell strings divided by the dividing grooves 8 running in the vertical direction are connected in parallel again. At the same time, a current-collecting electrode 7c for taking a center line is added between the two current-collecting electrodes 7a and 7b, dividing as a border the unit cell strings 10a into two, upper and lower, regions. Thereby, this integrated substrate 1 is divided to 12 × 2 = 24 regions. The current-collecting electrode 7c for taking a center line may be attached directly onto the second electrode 7 of the cell string as illustrated in FIG. 11(b). Alternatively, a space for an electrode for taking a center line may be provided between the upper region and the lower region for the attachment of the current-collecting electrode 7c.

FIG. 12 illustrates a circuit diagram of this thin-film solar cell module as a whole. Unit cell strings having a plurality of thin-film solar cell elements connected in series are connected to bypass diodes in parallel. Specifically, bypass diodes 12 are prepared in a terminal box 11, and lead wires 14, 15, 16 led out of each unit cell string 10a are arranged there to connect two cell strings to two bypass diodes 12 in parallel. Since the two bypass diodes 12 are connected in series, a plurality of cell strings are connected in series in a direction in which the plurality of thin-film solar cell elements are connected in series. Thereby, the number of series connections in the unit string can be held to the number of stages specified in the formula (1) or less and, at the same time, a two-fold voltage can be outputted between terminals 13.

While each unit cell string is connected within the terminal box 11 in the above-described Embodiment 1, it may be connected onto a supporting substrate 1 of the thin-film solar cell module by providing and using a wire. In this case, the wire provided on the supporting substrate 1 may be formed at the same time as the formation of the current-collecting electrode 7, or a separate wire such as a jumper wire may be used.

When a three-junction type cell in which two amorphous silicon cells and one microcrystalline silicon cell are laminated is used for the photoelectric conversion layer in the configuration of Embodiment 1, the calculation shown in the formula (1) will be as follows:

$$Rshm = 4000 \ [\Omega]$$

$$Vpm = 1.80 \ [V]$$

$$Ipm = 62 \ [mA]$$

$$n < Rshm \div 2.5 \div Vpm \ \times \ Ipm \ + \ 1 = 56.1$$

Therefore, since n needs to be 56 stages or less according to the formula (1), the first thin-film solar cell module is provided with the current-collecting electrode 7c for taking a center in the middle of its series structure of 106 stages, and each unit cell string 10a is of 53 stages.

In addition, while the first thin-film solar cell module has one current-collecting electrode 7c for taking a center, the number of lines for taking a center may be increased by increasing the number of divisions according to the number of integration stages of the substrate as a whole and individual cell voltage so that the number of integration stages per region is decreased. Furthermore, one block is acceptable when the output voltage is equal to or lower than the voltage to be obtained according to the number of stages of the formula (1).

<Second thin-film solar cell module>

- Embodiment of 53 stages $\times$ 6 parallels $\times$ 4 blocks in series -

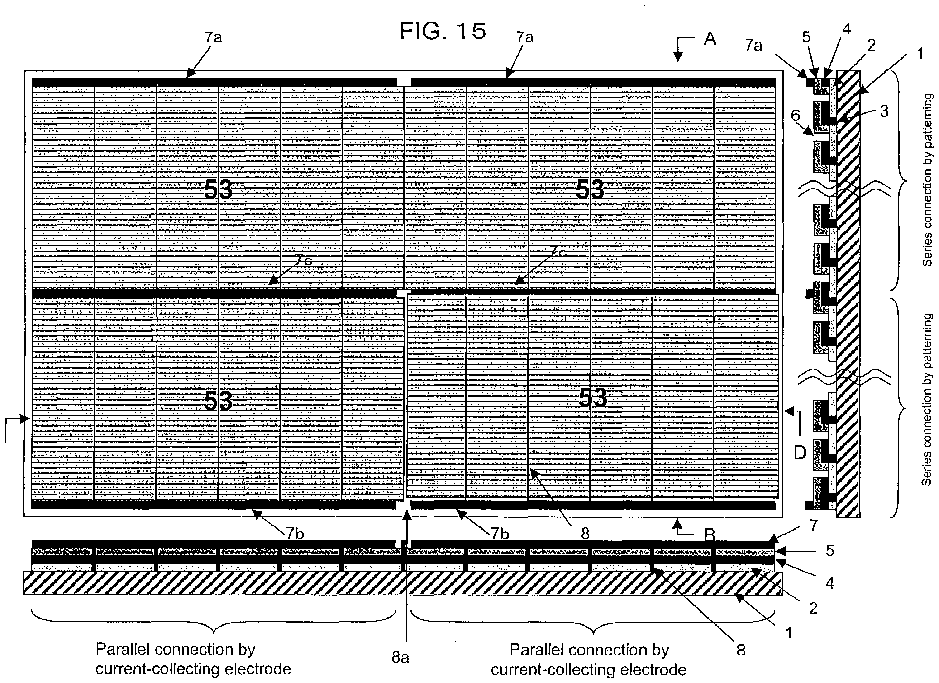

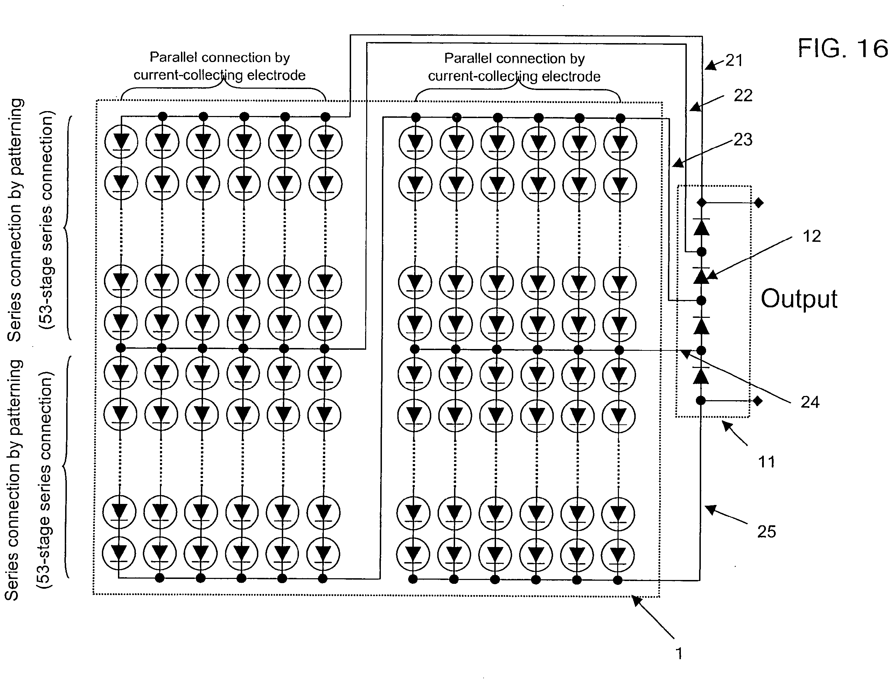

FIG. 15 illustrates an integrated second thin-film solar cell module of the present invention, and FIG. 15(a) is a plan view, FIG. 15(b) is a cross-sectional view taken along lines E-F of FIG. 15(a), and FIG. 15(c) is a cross-sectional view taken along lines G-H of FIG. 15(a). FIG. 16 illustrates a circuit diagram.

The second thin-film solar cell module is characterized in a connection method after division in order to output a higher voltage. The other configurations and the production method are the same as those of the first thin-film solar cell module. Specifically, processes up to the formation of the first electrode 2, the dividing scribe lines 3, the photoelectric conversion film 4, the second electrode 5, and the cell dividing grooves 6 are the same as those of the first thin-film solar cell module. Successively, the cell string is divided to 12 unit cell strings by the cell string dividing grooves 8 running in the vertical direction. At the time of the division, a middle string dividing groove 8a is made wider. Since a high voltage equivalent to half of the thin-film solar cell module operation voltage is applied to this part during power generation, it is necessary to ensure a breakdown voltage. In the second thin-film solar cell module, the string dividing groove 8a is approximately twice as wide as the other string dividing grooves 8. It is needless to say that the string dividing groove 8a may be filled with a resin, or an insulation film may be formed to increase a withstand voltage.

Thereafter, current-collecting electrodes 7a, 7b, 7c are formed separately so that each of them is divided into one for the cell string on the right in FIG. 15 and one for the cell string on the left in FIG. 15 to be independent electrodes. Thereby, four blocks of 53 stages of series connection × 6 parallels are completed. As shown in FIG. 16, wiring is made to the bypass diodes 12 within the terminal box 11 with the use of lead wires 21 to 25 to form a 4-block series connection. Thus, a thin-film solar cell module outputting a further voltage twice the voltage of the first thin-film solar cell module can be achieved. In other words, an output voltage that is 4 times that of one cell string is obtained. Therefore, a plurality of cell strings are connected in series in a direction in which a plurality of thin-film solar cell elements are connected in series, and a plurality of cell strings are connected in series in a direction perpendicular to the direction in which a plurality of thin-film solar cell elements are connected in series. Thereby, the number of series connections in a unit cell string can be held to the number of stages specified in the formula (1) or less and, at the same time, a four-fold voltage can be outputted between the terminals 13.

As for the wiring for the 4-block series connection, lead wires led from each block may be directly connected within the thin-film solar cell module, lead wires led from each block may be connected within the terminal box as illustrated in FIG. 16, or the wires may be connected in series after once being brought to outside of the module.

In addition, the bypass diodes 12 are attached to every series block in parallel as in the case of the first thin-film solar cell module. Thereby, the number of series connections in one region can be held to the number of stages specified in the formula (1) or less and, at the same time, a four-fold voltage can be outputted. As for the bypass diodes 12, a small and thin type may be built in the thin-film solar cell module or may be built in the terminal box.

When the cell string is divided in a direction different from the integration direction of the solar cell elements, for example, in a direction perpendicular thereto, and the divided is reconnected as in the case of the second thin-film solar cell module, a higher voltage can be achieved while keeping an optimum integration pitch, that is, a higher voltage can be achieved without losing module conversion efficiency, unlike the case in which the division is made only in the integration direction as in the case of the first thin-film solar cell module.

<Third thin-film solar cell module>

- Embodiment of 48 stages × 5 parallels × 4 blocks in series achieved by using two substrates of 48 stages × 5 parallels x 2 blocks in series -

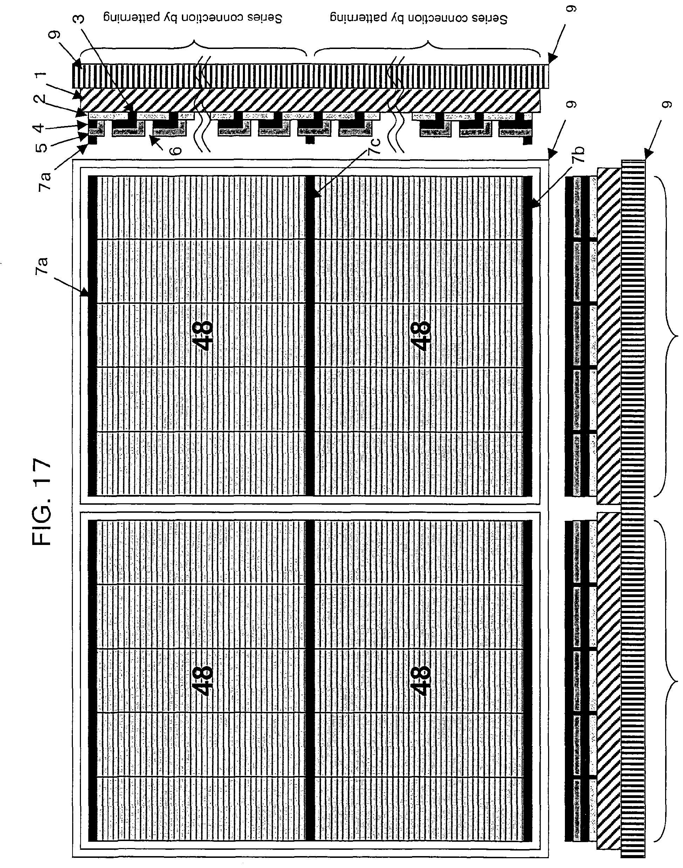

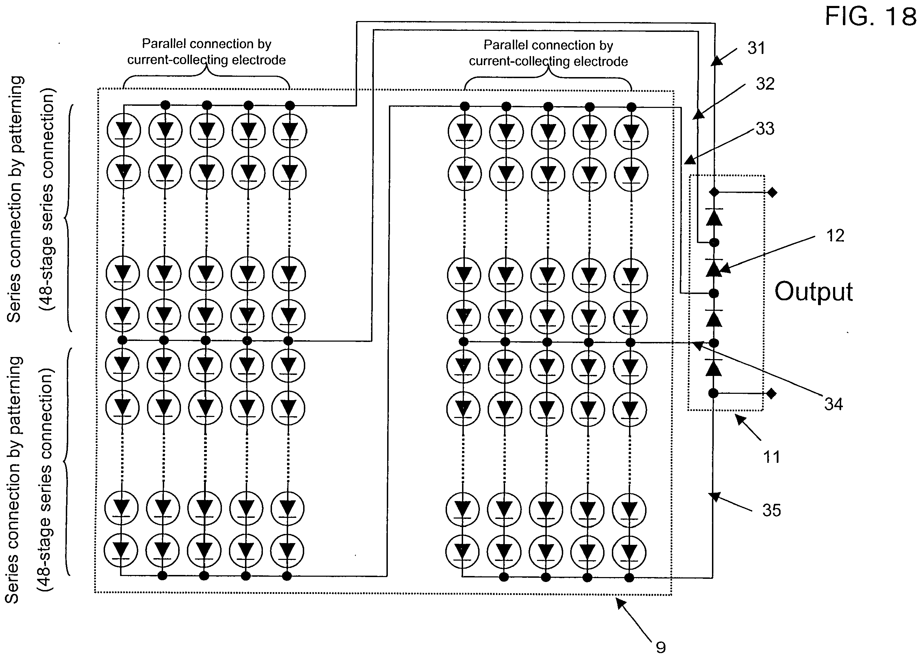

As for the first and second thin-film solar cell modules, the supporting substrate itself is large, and have been described examples of the thin-film solar cell module in which all cell strings are formed on the substrate. However, even in the case where a plurality of small supporting substrates are combined to form a large solar cell module, similar problems will arise. In that case, a module of high voltage can be produced while ensuring reliability by forming cell strings in respective supporting substrates so that the requirement shown in the formula (1) is met and connecting the cell strings together. That is, the cell strings are formed in the same manner as in Embodiments 1 and 2, and arranged in two small sized integrated substrates connected in parallel on one integrated substrate 9 as illustrated in FIG. 17. That is, two supporting substrates 1 of the thin-film solar cell module are mounted on the integrated substrate 9 formed of one cover glass, and configured to be integrated together as illustrated in FIG. 17. And, they are connected in series in the terminal box 11 as illustrated in FIG. 18.

The above-described small supporting substrates may be sealed separately to be integrated on the integrated substrate as illustrated in FIG. 17, or may be integrated by using a frame. Or, the two small supporting substrates may be mounted on one integrated substrate and sealed to be integrated together as described above. Or, the two supporting substrates may be sealed separately and integrated with the use of a frame to form one thin-film solar cell module.

The solar cell modules for outputting high voltages are described above, and, next, solar cell modules for outputting low voltages will be described.

<Fourth thin-film solar cell module>

- Embodiment of 20 stages × 12 parallels × 1 block -

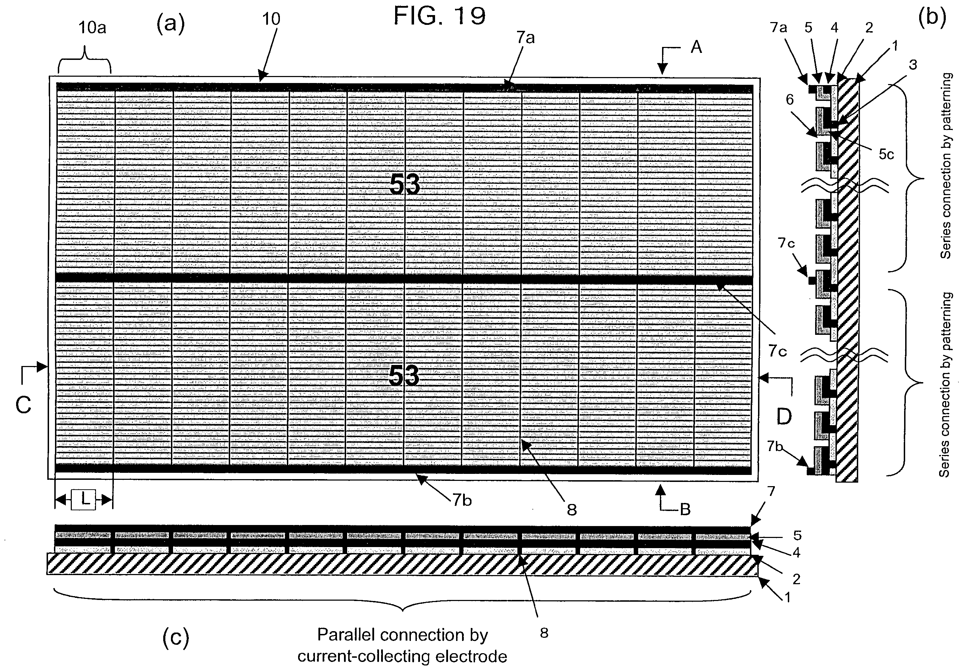

FIG. 19 illustrates an integrated thin-film solar cell module according to the fourth thin-film solar cell module of the present invention, and FIG. 19 (a) is a plan view, FIG. 19 (b) is a longitudinal-sectional view of FIG. 19 (a), and FIG. 19 (c) is a cross-sectional view of FIG. 19 (a).

The fourth thin-film solar cell module 10 outputs a low voltage and the stage number of a connection in-series is 20 and the arrays of 12 parallels are structured. The other construction is the same as the first thin-film solar cell module.

The first to fourth thin-film solar cell modules as above mentioned are described as a thin-film solar cell module of a superstraight structure. However, a thin-film solar cell module of a sub-straight structure is also applicable. In that case, the second electrode, the photoelectric conversion layer, and the first electrode are formed on the substrate in this order

In addition, while the above-described first to fourth thin-film solar cell modules are each provided with one terminal box, they may be each provided with a plurality of terminal boxes, and a plurality of terminal books may be wired to connect the cell strings in series.

Furthermore, as for the above-described first to fourth thin-film solar cell modules, two cell strings are formed and divided into two; however, one cell string may be acceptable when the output voltage is satisfiable by the number of stages n of the cell strings. Moreover, the number of cell strings does not need to be an even number, and may be an odd number.

In addition, as for the above-described first to fourth thin-film solar cell modules, the cell strings are connected in series through the connection to the bypass diodes; however, other protective circuits than the bypass diodes may be used. For example, electronic diode-less protective circuits may be used.

(Embodiment 2)

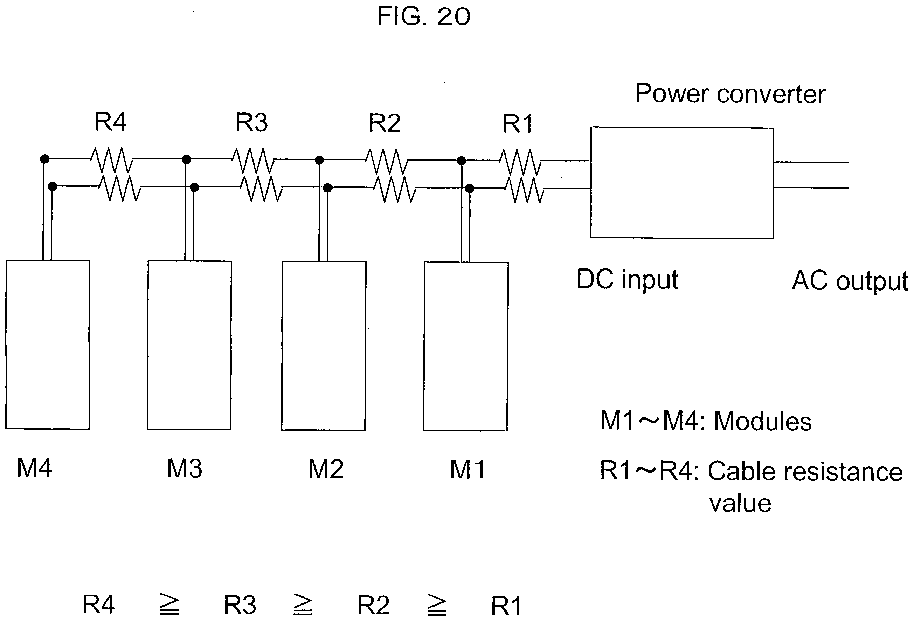

FIG. 20 illustrates a block diagram of a solar power generation system according to Embodiment 2. As illustrated in FIG. 20, the thin-film solar cell modules are characterized in that they are respectively provided with resistances R1, R2, R3 and R4 connected in parallel in trunk lines S1 and S2. The resistances R1, R2, R3 and R4 are connected such that the closer the resistances R1, R2, R3, R4 are to a DC/AC converter DA, the smaller the value of resistance is. The resistances R1, R2, R3 and R4 can be formed with internal resistances of the trunk lines S1 and S2. The resistances R1, R2, R3 and R4 are connected to each of the trunk lines S1 and S2 in FIG. 20, but either one of the trunk lines S1 and S2 may be all right. When the resistances R1, R2, R3 and R4 are formed with the internal resistances of the trunk lines S1 and S2, the thickness or the number of the trunk lines S1 and S2 may be changed as necessary. The resistances R1, R2, R3 and R4 equalize the voltages at an input terminal of the DC/AC converter DA.

The other configurations are the same as those of Embodiment 1. The first to fourth thin-film solar cell modules forming the thin-film solar cell modules are also the same as those of Embodiment 1.

(Embodiment 3)

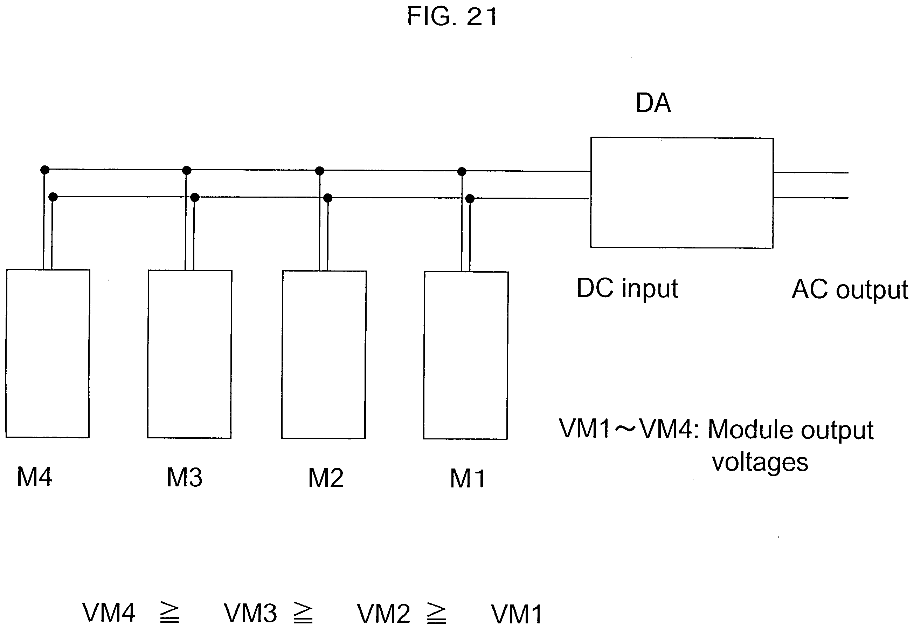

FIG. 21 illustrates a block diagram of a power generation system according to Embodiment 4. As illustrated in FIG. 21, the output voltages of a plurality of thin-film solar cell strings are higher as they are further from a DC/AC converter DA and lower as they are closer to the DC/AC converter DA. And, the voltages are equalized at an input terminal of the DC/AC converter DA. When the plurality of thin-film solar cell strings have uneven output voltages, they may be arranged in order of output voltage so that the thin-film solar cell strings having a lower output voltage is at the input terminal of the DC/AC converter DA.

The other configurations are the same as those of Embodiment 1. The first to third thin-film solar cell modules forming the thin-film solar cell strings are also the same as those of Embodiment 1.

As for Embodiments 1 to 3, examples have been described in which a DC/AC converting circuit is used as a power converter; however, the effects of the present invention are not limited to the DC/AC converting circuit. For example, the same effects can be obtained from a solar power generation system in which a DC/AC converting circuit is used for a power converting circuit.

The solar power generation system of the present invention is constructed so that the above-described blocking diodes are provided. Thereby, the short-circuit failure and the open-circuit failure of the solar cell strings can be easily detected as described below.

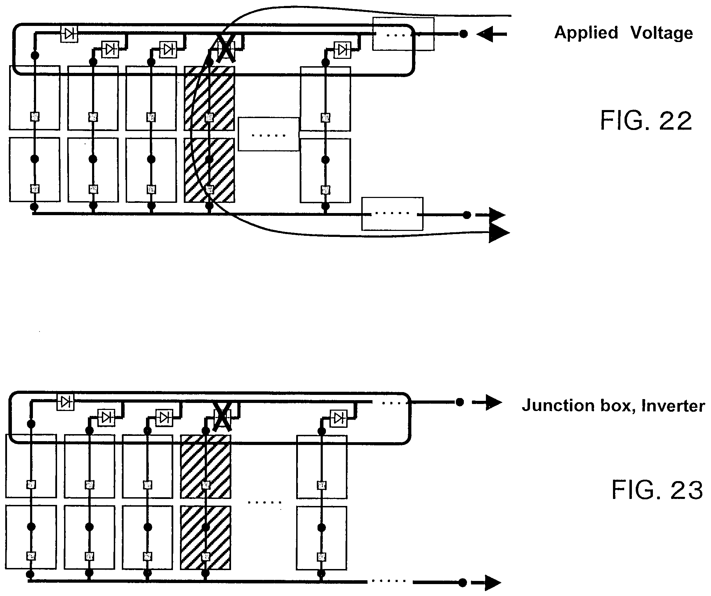

FIG. 22 is an explanatory diagram of detecting short-circuit failure of the solar cell strings, in which the blocking diodes 141 are coupled to a plus electrode of the two solar cell modules 111 and 112 connected in series. A voltage is applied to the plus electrode in such a condition that the solar cell modules are not exposed to light at night in the solar power generation system. Hence, a current can flow through the solar cell module whose blocking diode in failure is short circuited to thereby heat the solar cell module. The temperature of the heated solar cell module is higher several degrees than the other solar cell modules. An observation using a thermograph or the like enables the detection of the distinction between the heated solar cell and the other solar cell modules to identify the position of the heated solar cell module. The effect of observing using the thermograph and detecting the failure is effective for the solar power generation system of the present invention comprising a number of solar cell modules connected in parallel. It is especially effective for the case where the number of the in-series connection is as little as about 2 to 10 and the number of the in-parallel connection is as great as about several tens. Thus, a voltage is applied from the trunk lines to observe the heat generation of the solar cell modules in order to enable the examination of a failure of the blocking diodes.

FIG. 23 is an explanatory diagram of detecting open-circuit failure of the solar cell strings, in which the blocking diodes 141 are coupled to a plus electrode of the two solar cell modules 111 and 112 connected in series. The inverter is operated in the daytime in the solar generation system. Hence, the solar cell module whose blocking diode in failure is open-circuited is heated higher than the heat temperature of the other solar cell modules. That is, the solar cell modules that are ordinarily operated are heated by a power generation current, but the solar cell module whose blocking diode is open-circuited in failure is heated without flowing the power generation current to be correspondingly at a higher temperature. The temperature of the heated solar cell module is higher several degrees than the other solar cell modules. An observation using a thermograph or the like enables the detection of the distinction between the heated solar cell and the other solar cell modules. The effect of observing using the thermograph and detecting the failure is effective for the solar power generation system of the present invention comprising a number of solar cell modules connected in parallel. It is especially effective for the case where the number of the in-series connection is as little as about 2 to 10 and the number of the in-parallel connection is as great as about several thousands. Thus, a voltage is applied from the trunk lines to observe the heat generation of the solar cell modules in order to enable the examination of a failure of the blocking diodes.

Since these phenomena are caused in the case where the solar cell modules are damaged, this method can be used to detect the failure of the solar cell modules.

**DESCRIPTION OF THE REFERENCE NUMERALS**

| | |
|---|---|
| 101, 102 | Trunk line |
| 121 | Solar cell string |
| 131, 132 | Branch line |
| 141 | Blocking diode |
| 140 | Branch connection unit |
| 140a | Large heat sink |
| 140b | Small heat sink |
| 111, 112 | Thin-film solar cell module |
| R1, R2, R3, R4 | Resistance |
| VM1, VM2, VM3, VM4 | Output voltage of thin-film solar cell module |

**Claims**

1. A power line system for a solar power generation system comprising:

   trunk lines (101, 102) for extracting power;
   a plurality of branch lines (131, 132) interconnected in parallel, which are connected across the trunk lines (101, 102);
   solar cell modules (111, 112) connected to the branch lines (131, 132); and
   a blocking diode (141) one terminal (141a) of which is connected to the trunk lines (101, 102) and the other terminal of which is connected to the solar cell modules (111, 112) through the branch lines (131, 132), wherein a branch connection unit (140) is provided at a connection portion between the trunk lines (101, 102) and the branch lines (131, 132) and a heat sink (140a, 140b) is stored within the branch connection unit (140);
   one terminal of the blocking diode (141) being electrically connected to the heat sink (140a, 140b) which is connected to either the trunk lines (101, 102) or the branch lines (131, 132), so as to dissipate the heat of the blocking diode (141) through the heat sink (140a, 140b); and
   the blocking diode (141) is thermally combined with the heat sink (140a, 140b).

2. The power line system for the solar power generation system according to claim 1, wherein the blocking diode (141) is stored within a container into which a potting agent is filled.

3. The power line system for the solar power generation system according to any one of claims 1 to 2, wherein the trunk lines (101, 102) are arranged such that they are thicker in a power collecting end and thinner in a distal end at the branch connection (140) unit with the branch lines (131, 132).

4. A solar power generation system constructed with the power line system according to any one of claims 1 to 3.

5. A solar power generation system according to claim 4, wherein the trunk lines (101, 102) comprise a low-voltage side wiring and a high-voltage side wiring, and the blocking diode (141) is connected to the branch lines (131, 132) coupled to the low-voltage side wiring.

6. A solar power generation system according to claim 5, wherein the low-voltage side wiring and the high-voltage side wiring are collectively integrated, and the branch lines (131, 132) connected to the low-voltage side wiring and the high-voltage side are positioned across both sides of the trunk lines (101, 102), respectively, so that the solar cell modules (111, 112) are connected to the branch lines (131, 132).

7. A solar power generation system according to claim 4, wherein the low-voltage side wiring and the high-voltage side wiring are collectively integrated, and the branch lines (131, 132) connected to the low-voltage side wiring are positioned at one side of the trunk lines (101, 102), while the branch lines (131, 132) connected to the high-voltage side wiring are positioned at the other side of the trunk lines (101, 102) so that the solar cell modules (111, 112) are each connected to the branch lines (131, 132), and connection lines for connecting the solar cell modules (111, 112) are provided.

8. A method for inspecting malfunction of a solar power generation system comprising a power line system comprising:

trunk lines (101, 102) for extracting power;
a plurality of branch lines (131, 132) interconnected in parallel, which are connected across the trunk lines (101, 102);
solar cell modules (111, 112) connected to the branch lines (131, 132); and
a blocking diode (141) one terminal (141a) of which is connected to the trunk lines (101, 102) and the other terminal of which is connected to the solar cell modules (111, 112) through the branch lines (131, 132), wherein a branch connection unit (140) is provided at a connection portion between the trunk lines (101, 102) and the branch lines (131, 132) and a heat sink (140a, 140b) is stored within the branch connection unit (140);
one terminal of the blocking diode (141) being electrically connected to the heat sink (140a, 140b) which is connected to either the trunk lines (101, 102) or the branch lines (131, 132), so as to dissipate the heat of the blocking diode (141) through the heat sink (140a, 140b); and
the blocking diode (141) is thermally combined with the heat sink (140a, 140b), the method comprising:

providing the blocking diode (141) with the branch lines (131, 132) connected to a low-voltage side wiring or high-voltage side wiring; and
applying a voltage from the trunk lines (101, 102) including the branch lines (131, 132) to which the blocking diode (141) is unconnected,

wherein earth resistances of solar cell modules are inspected.

9. A method for inspecting malfunction of a solar power generation system comprising a power line system comprising:

trunk lines (101, 102) for extracting power;
a plurality of branch lines (131, 132) interconnected in parallel, which are connected across the trunk lines (101, 102);
solar cell modules (111, 112) connected to the branch lines (131, 132); and
a blocking diode (141) one terminal (141a) of which is connected to the trunk lines (101, 102) and the other terminal of which is connected to the solar cell modules (111, 112) through the branch lines (131, 132), wherein a branch connection unit (140) is provided at a connection portion between the trunk lines (101, 102) and the branch lines (131, 132) and a heat sink (140a, 140b) is stored within the branch connection unit (140);
one terminal of the blocking diode (141) being electrically connected to the heat sink (140a, 140b) which is connected to either the trunk lines (101, 102) or the branch lines (131, 132), so as to dissipate the heat of the blocking diode (141) through the heat sink (140a, 140b); and
the blocking diode (141) is thermally combined with the heat sink (140a, 140b), comprising:

providing the blocking diode (141) with the branch lines (131, 132) connected to a low-voltage side wiring or high-voltage side wiring; and
applying a voltage from the trunk lines (101, 102) including the branch lines (131, 132) to which the blocking diode (141) is unconnected,

wherein heat generation of solar cell modules is observed.

**Patentansprüche**

1. Stromleitungssystem für ein Solarstromerzeugungssystem, umfassend:

   Hauptleitungen (101, 102), um Strom zu extrahieren;
   eine Vielzahl parallel miteinander verbundener Zweigleitungen (131, 132), die über die Hauptleitungen (101, 102) verbunden sind;
   Solarzellenmodule (111, 112), die mit den Zweigleitungen (131, 132) verbunden sind; und
   eine Sperrdiode (141), deren ein Anschluss (141a) mit den Hauptleitungen (101, 102) verbunden ist und deren anderer Anschluss über die Zweigleitungen (131, 132) mit den Solarzellenmodulen (111, 112) verbunden ist, wobei
   eine Zweigverbindungseinheit (140) an einem Verbindungsteil zwischen den Hauptleitungen (101, 102) und den Zweigleitungen (131, 132) vorgesehen ist und ein Kühlkörper (140a, 140b) innerhalb der Zweigverbindungseinheit (140) untergebracht ist;
   ein Anschluss der Sperrdiode (141) mit dem Kühlkörper (140a, 140b) elektrisch verbunden ist, der mit entweder den Hauptleitungen (101, 102) oder den Zweigleitungen (131, 132) verbunden ist, um die Wärme der Sperrdiode (141) über den Kühlkörper (140a, 140b) abzuleiten; und
   die Sperrdiode (141) mit dem Kühlkörper (140a, 140b) thermisch kombiniert ist.

2. Stromleitungssystem für das Solarstromerzeugungssystem nach Anspruch 1, wobei die Sperrdiode (141) innerhalb eines Behälters untergebracht ist, in den ein Vergussmittel gefüllt ist.

3. Stromleitungssystem für das Solarstromerzeugungssystem nach einem der Ansprüche 1 bis 2, wobei die Hauptleitungen (101, 102) so angeordnet sind, dass sie in einem Stromsammelende dicker und in einem Distalende bei der Zweigverbindungseinheit (140) mit den Zweigleitungen (131, 132) dünner sind.

4. Solarstromerzeugungssystem, das mit dem Stromleitungssystem nach einem der Ansprüche 1 bis 3 aufgebaut ist.

5. Solarstromerzeugungssystem nach Anspruch 4, wobei die Hauptleitungen (101, 102) eine niederspannungsseitige Verdrahtung und eine hochspannungsseitige Verdrahtung umfassen und die Sperrdiode (141) mit den Zweigleitungen (131, 132) verbunden ist, die mit der niederspannungsseitigen Verdrahtung gekoppelt sind.

6. Solarstromerzeugungssystem nach Anspruch 5, wobei die niederspannungsseitige Verdrahtung und die hochspannungsseitige Verdrahtung gemeinsam integriert sind und die Zweigleitungen (131, 132), die mit der niederspannungsseitigen Verdrahtung und der hochspannungsseitigen Verdrahtung verbunden sind, über beide Seiten der Hauptleitungen (101, 102) jeweils angeordnet sind, so dass die Solarzellenmodule (111, 112) mit den Zweigleitungen (131, 132) verbunden sind.

7. Solarstromerzeugungssystem nach Anspruch 4, wobei die niederspannungsseitige Verdrahtung und die hochspannungsseitige Verdrahtung gemeinsam integriert sind und die Zweigleitungen (131, 132), die mit der niederspannungsseitigen Verdrahtung verbunden sind, an einer Seite der Hauptleitungen (101, 102) angeordnet sind, während die Zweigleitungen (131, 132), die mit der hochspannungsseitigen Verdrahtung verbunden sind, an der anderen Seite der Hauptleitungen (101, 102) angeordnet sind, so dass die Solarzellenmodule (111, 112) jeweils mit den Zweigleitungen (131, 132) verbunden sind, und Verbindungsleitungen zum Verbinden der Solarzellenmodule (111, 112) vorgesehen sind.

8. Verfahren zum Untersuchen einer Fehlfunktion eines Solarstromerzeugungssystems mit einem Stromleitungssystem, umfassend:

   Hauptleitungen (101, 102), um Strom zu extrahieren;
   eine Vielzahl parallel miteinander verbundener Zweigleitungen (131, 132), die über die Hauptleitungen (101, 102) verbunden sind;
   Solarzellenmodule (111, 112), die mit den Zweigleitungen (131, 132) verbunden sind; und
   eine Sperrdiode (141), deren ein Anschluss (141a) mit den Hauptleitungen (101, 102) verbunden ist und deren anderer Anschluss über die Zweigleitungen (131, 132) mit den Solarzellenmodulen (111, 112) verbunden ist, wobei
   eine Zweigverbindungseinheit (140) an einem Verbindungsteil zwischen den Hauptleitungen (101, 102) und den Zweigleitungen (131, 132) vorgesehen ist und ein Kühlkörper (140a, 140b) innerhalb der Zweigverbindungseinheit (140) untergebracht ist;

ein Anschluss der Sperrdiode (141) mit dem Kühlkörper (140a, 140b) elektrisch verbunden ist, der mit entweder den Hauptleitungen (101, 102) oder den Zweigleitungen (131, 132) verbunden ist, um die Wärme der Sperrdiode (141) über den Kühlkörper (140a, 140b) abzuleiten; und

die Sperrdiode (141) mit dem Kühlkörper (140a, 140b) thermisch kombiniert ist, wobei das Verfahren umfasst:

Vorsehen der Sperrdiode (141) mit den Zweigleitungen (131, 132), die mit einer niederspannungsseitigen Verdrahtung oder hochspannungsseitigen Verdrahtung verbunden sind; und

Anlegen einer Spannung von den Hauptleitungen (101, 102) einschließlich der Zweigleitungen (131, 132), womit die Sperrdiode (141) nicht verbunden ist,

wobei Erdungswiderstände von Solarzellenmodulen untersucht werden.

9. Verfahren zum Untersuchen einer Fehlfunktion eines Solarstromerzeugungssystems mit einem Stromleitungssystem, umfassend:

Hauptleitungen (101, 102), um Strom zu extrahieren;

eine Vielzahl parallel miteinander verbundener Zweigleitungen (131, 132), die über die Hauptleitungen (101, 102) verbunden sind;

Solarzellenmodule (111, 112), die mit den Zweigleitungen (131, 132) verbunden sind; und

eine Sperrdiode (141), deren ein Anschluss (141a) mit den Hauptleitungen (101, 102) verbunden ist und deren anderer Anschluss über die Zweigleitungen (131, 132) mit den Solarzellenmodulen (111, 112) verbunden ist, wobei

eine Zweigverbindungseinheit (140) an einem Verbindungsteil zwischen den Hauptleitungen (101, 102) und den Zweigleitungen (131, 132) vorgesehen ist und ein Kühlkörper (140a, 140b) innerhalb der Zweigverbindungseinheit (140) untergebracht ist;

ein Anschluss der Sperrdiode (141) mit dem Kühlkörper (140a, 140b) elektrisch verbunden ist, der mit entweder den Hauptleitungen (101, 102) oder den Zweigleitungen (131, 132) verbunden ist, um die Wärme der Sperrdiode (141) über den Kühlkörper (140a, 140b) abzuleiten; und

die Sperrdiode (141) mit dem Kühlkörper (140a, 140b) thermisch kombiniert ist, umfassend:

Vorsehen der Sperrdiode (141) mit den Zweigleitungen (131, 132), die mit einer niederspannungsseitigen Verdrahtung oder hochspannungsseitigen Verdrahtung verbunden sind; und

Anlegen einer Spannung von den Hauptleitungen (101, 102) einschließlich der Zweigleitungen (131, 132), womit die Sperrdiode (141) nicht verbunden ist,

wobei eine Wärmeerzeugung von Solarzellenmodulen beobachtet wird.

## Revendications

1. Système de lignes électriques pour un système générateur d'énergie solaire comprenant :

des lignes principales (101, 102) pour l'extraction du courant ;

plusieurs lignes de branchement (131, 132) interconnectées en parallèle, qui sont montées en travers des lignes principales (101, 102) ;

des modules de cellules solaires (111, 112) reliés aux lignes de branchement (131, 132) ; et

une diode de blocage (141) dont une borne (141a) est reliée aux lignes principales (101, 102) et dont l'autre borne est reliée aux modules de cellules solaires (111, 112) par les lignes de branchement (131, 132),

une unité de liaison de branchements (140) étant disposée au niveau d'une partie de liaison entre les lignes principales (101, 102) et les lignes de branchement (131, 132), et un puits de chaleur (140a, 140b) étant stocké à l'intérieur de l'unité de liaison de branchements (140) ;

une borne de la diode de blocage (141) étant reliée électriquement au puits de chaleur (140a, 140b) qui est relié aux lignes principales (101, 102) ou aux lignes de branchement (131, 132), de manière à dissiper la chaleur de la diode de blocage (141) à travers le puits de chaleur (140a, 140b) ; et

la diode de blocage (141) étant combinée thermiquement avec le puits de chaleur (140a, 140b).

2. Système de lignes électriques pour le système générateur d'énergie solaire selon la revendication 1, dans lequel la diode de blocage (141) est stockée à l'intérieur d'un contenant dans lequel est placé un agent d'enrobage.

3. Système de lignes électriques pour le système générateur d'énergie solaire selon l'une quelconque des revendications 1 à 2, dans lequel les lignes principales (101, 102) sont disposées de telle sorte qu'elles sont plus épaisses dans une extrémité de captage de courant, et plus minces dans une extrémité distale au niveau de l'unité de liaison de branchements (140) avec les lignes de branchement (131, 132).

4. Système générateur d'énergie solaire construit avec le système de lignes électriques selon l'une quelconque des revendications 1 à 3.

5. Système générateur d'énergie solaire selon la revendication 4, dans lequel les lignes principales (101, 102) comprennent un câblage de côté basse tension et un câblage de côté haute tension, et la diode de blocage (141) est reliée aux lignes de branchement (131, 132) couplées au câblage de côté basse tension.

6. Système générateur d'énergie solaire selon la revendication 5, dans lequel le câblage de côté basse tension et le câblage de côté haute tension sont intégrés collectivement, et les lignes de branchement (131, 132) reliées au câblage de côté basse tension et au côté haute tension sont placées des deux côtés des lignes principales (101, 102), respectivement, de sorte que les modules de cellules solaires (111, 112) sont reliés aux lignes de branchement (131, 132).

7. Système générateur d'énergie solaire selon la revendication 4, dans lequel le câblage de côté basse tension et le câblage de côté haute tension sont intégrés collectivement, et les lignes de branchement (131, 132) reliées au câblage de côté basse tension sont placées sur un côté des lignes principales (101, 102) tandis que les lignes de branchement (131, 132) reliées au côté haute tension sont placées sur l'autre côté des lignes principales (101, 102) de telle sorte que les modules de cellules solaires (111, 112) soient reliés chacun aux lignes de branchement (131, 132), et des lignes de liaison pour relier les modules de cellules solaires (111, 112) sont prévues.

8. Procédé d'inspection d'une anomalie d'un système générateur d'énergie solaire comprenant un système de lignes électriques comprenant :

    des lignes principales (101, 102) pour l'extraction du courant ;
    plusieurs lignes de branchement (131, 132) interconnectées en parallèle, qui sont montées en travers des lignes principales (101, 102) ;
    des modules de cellules solaires (111, 112) reliés aux lignes de branchement (131, 132) ; et
    une diode de blocage (141) dont une borne (141a) est reliée aux lignes principales (101, 102) et dont l'autre borne est reliée aux modules de cellules solaires (111, 112) par les lignes de branchement (131, 132),
    une unité de liaison de branchements (140) étant disposée au niveau d'une partie de liaison entre les lignes principales (101, 102) et les lignes de branchement (131, 132), et un puits de chaleur (140a, 140b) étant stocké à l'intérieur de l'unité de liaison de branchements (140) ;
    une borne de la diode de blocage (141) étant reliée électriquement au puits de chaleur (140a, 140b) qui est relié aux lignes principales (101, 102) ou aux lignes de branchement (131, 132), de manière à dissiper la chaleur de la diode de blocage (141) à travers le puits de chaleur (140a, 140b) ; et
    la diode de blocage (141) étant combinée thermiquement avec le puits de chaleur (140a, 140b), le procédé comprenant les mesures consistant :

        à prévoir la diode de blocage (141) avec les lignes de branchement (131, 132) reliées à un câblage de côté basse tension ou à un câblage de côté haute tension ; et
        à appliquer une tension à partir des lignes principales (101, 102) comprenant les lignes de branchement (131, 132) auxquelles la diode de blocage (141) n'est pas reliée,

    des résistances à la terre de modules de cellules solaires étant inspectées.

9. Procédé d'inspection d'une anomalie d'un système générateur d'énergie solaire comprenant un système de lignes électriques comprenant :

    des lignes principales (101, 102) pour l'extraction du courant ;
    plusieurs lignes de branchement (131, 132) interconnectées en parallèle, qui sont montées en travers des lignes principales (101, 102) ;

des modules de cellules solaires (111, 112) reliés aux lignes de branchement (131, 132) ; et

une diode de blocage (141) dont une borne (141a) est reliée aux lignes principales (101, 102) et dont l'autre borne est reliée aux modules de cellules solaires (111, 112) par les lignes de branchement (131, 132),

une unité de liaison de branchements (140) étant disposée au niveau d'une partie de liaison entre les lignes principales (101, 102) et les lignes de branchement (131, 132), et un puits de chaleur (140a, 140b) étant stocké à l'intérieur de l'unité de liaison de branchements (140) ;

une borne de la diode de blocage (141) étant reliée électriquement au puits de chaleur (140a, 140b) qui est relié aux lignes principales (101, 102) ou aux lignes de branchement (131, 132), de manière à dissiper la chaleur de la diode de blocage (141) à travers le puits de chaleur (140a, 140b) ; et

la diode de blocage (141) étant combinée thermiquement avec le puits de chaleur (140a, 140b), comprenant les mesures consistant :

à prévoir la diode de blocage (141) avec les lignes de branchement (131, 132) reliées à un câblage de côté basse tension ou à un câblage de côté haute tension ; et

à appliquer une tension à partir des lignes principales (101, 102) comprenant les lignes de branchement (131, 132) auxquelles la diode de blocage (141) n'est pas reliée,

la production de chaleur des modules de cellules solaires étant observée.

FIG. 1

EP 2 284 908 B1

EP 2 284 908 B1

FIG. 2

2.5mm²  4.0mm²  6.0mm²

101

141

→ Junction box

FIG. 3(a)

FIG. 3(b)

FIG. 3(c)

FIG. 3(d)

FIG. 3(e)

FIG. 3(f)

EP 2 284 908 B1

EP 2 284 908 B1

FIG. 4

FIG. 5

FIG. 6

FIG. 7

FIG. 8

FIG. 9

FIG. 10

EP 2 284 908 B1

# FIG. 11

(a)

(b)

(c)

Parallel connection by
current-collecting electrode

Series connection by patterning

EP 2 284 908 B1

FIG. 12

FIG. 13

Rsh-Prsh property

FIG. 14

FIG. 15

Series connection by patterning

Series connection by patterning

Parallel connection by
current-collecting electrode

Parallel connection by
current-collecting electrode

FIG. 16

Output

Parallel connection by current-collecting electrode

Parallel connection by current-collecting electrode

Series connection by patterning
(53-stage series connection)

Series connection by patterning
(53-stage series connection)

EP 2 284 908 B1

FIG. 18

Parallel connection by current-collecting electrode

Parallel connection by current-collecting electrode

Series connection by patterning (48-stage series connection)

Series connection by patterning (48-stage series connection)

Output

31

32

33

12

34

11

35

9

EP 2 284 908 B1

FIG. 19

(a)

(b)

(c) Parallel connection by
current-collecting electrode

EP 2 284 908 B1

FIG. 20

Power converter

DC input

AC output

R1 R2 R3 R4

M1 M2 M3 M4

M1∼M4: Modules

R1∼R4: Cable resistance value

R4 ≧ R3 ≧ R2 ≧ R1

FIG. 21

DA

DC input                    AC output

M4        M3        M2        M1

VM1～VM4: Module output
voltages

VM4  ≧  VM3  ≧  VM2  ≧  VM1

EP 2 284 908 B1

EP 2 284 908 B1

Applied Voltage

FIG. 22

Junction box, Inverter

FIG. 23

**EP 2 284 908 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1705718 A1
- US 6515215 B1
- DE 102004036697 A1
- JP HEI101998326902 B